# EUROPEAN PATENT SPECIFICATION

(11) **EP 0 113 959 B1**
(45) Date of publication and mention of the grant of the patent: **16.06.1993**
(21) Application number: 83307192.1
(22) Date of filing: 24.11.1983
(51) Int. Cl.: H01L 27/14, H01L 31/18, H01L 31/02

(54) **Photoelectric conversion device**
Fotovoltaischer Wandler
Dispositif de conversion photovoltaique

(30) Priority: 24.11.1982 JP 206806/82; 24.11.1982 JP 206809/82; 22.02.1983 JP 28211/83; 29.04.1983 JP 75713/83; 27.06.1983 JP 115640/83; 31.10.1983 JP 204443/83
(43) Date of publication of application: 25.07.1984
(73) Proprietor: SEMICONDUCTOR ENERGY LABORATORY CO., LTD., Setagaya-ku Tokyo 157 (JP)
(72) Inventor: Yamazaki, Shunpei c/o Semiconductor Energy, Setagaya-ku Tokyo (JP); Itoh, Kenji c/o Semiconductor Energy, Setagaya-ku Tokyo (JP); Watabe, Satsuki c/o Semiconductor Energy, Setagaya-ku Tokyo (JP)
(74) Representative: Wright, Peter David John

(56) References cited:
- WO-A-83/00409
- GB-A- 2 080 621
- GB-A- 2 095 908
- US-A- 2 428 537
- US-A- 4 262 411
- US-A- 4 281 208
- US-A- 4 292 092

## Description

The present invention relates to improvement in or relating to a photoelectric conversion device in which a number of semiconductor elements are sequentially arranged on a substrate in side-by-side relation and connected in series. The invention also pertains to a method for the manufacture of such a photoelectric conversion device.

### Description of the Prior Art

There has been proposed in GB-A-2080621 and US-A-4315096 a photoelectric conversion device comprising a substrate having an insulating surface and a plurality of semiconductor elements U₁ to Uₙ (n being an integer larger than one) formed thereon in side by side relationship and connected sequentially in series one with another, the semiconductor element Uᵢ (i=1,2,...n) comprising a first electrode Eᵢ formed on the substrate, a non-single-crystal semiconductor laminate member Qᵢ formed on the first electrode Eᵢ and having formed therein at least one semiconductor junction, and a second electrode Fᵢ formed on the non-single-crystal semiconductor laminate member Qᵢ in opposing relationship to the first electrode Eᵢ, and the second electrode Fⱼ₊₁ (j=1,2,...(n-1)) of the semiconductor element Uⱼ₊₁ being coupled with the first electrode Eⱼ of the semiconductor element Uⱼ through a coupling portion Kⱼ comprising an integrally formed extension of the second electrode Fⱼ₊₁.

In such a photoelectric conversion device, in order to prevent the photoelectric conversion efficiency of the device from deteriorating with time, it is necessary that the non-single-crystal semiconductor laminate member Qᵢ and the second electrode Fᵢ be held in good contact with each other for a long period of time.

In the photoelectric conversion device of the abovesaid patents, however, no particular attention is paid to such a structure that ensured to retain good contact between the non-single-crystal semiconductor laminate member Qᵢ and the second electrode Fᵢ.

Accordingly, this conventional photoelectric conversion device has the defect that high photoelectric conversion efficiency cannot be maintained for a long period of time.

Further, it is described in the abovesaid patents that the second electrode Fᵢ is formed from a conductive layer through laser beam scanning. However, no account is taken of the fact that during the laser beam scanning conductive material from the conductive layer will enter into the non-single-crystal semiconductor laminate member and impair the electrical insulation between the second electrodes Fⱼ and Fⱼ₊₁. Accordingly, the electrical insulation between the second electrodes Fⱼ and Fⱼ₊₁ is poor.

Therefore the photoelectric conversion device of the abovesaid patents has the defect of low photoelectric conversion efficiency.

A similar photoelectric conversion device to that disclosed in the aforesaid patents is disclosed in GB-A-2095908 and, as with the case of the first-mentioned device, the device of GB-A-2095908 is formed in a manner which takes no account of the problems arising from delamination of the second electrode Fᵢ from the non-single-crystal semiconductor laminate member Qᵢ and from semiconductor laminate deterioration due to interactions with contact material. The device of GB-A-2095908 is thus considered likely to suffer from the same problems as the device of GB-A-2080621 and US-A-4315096.

The applicants are also aware of WO-A-8300409 which was published on 3 February 1983, namely after the earliest claimed priority date (24 November 1982) of the present application, but does itself claim the earlier priority date of 16 July 1981. The disclosure of W0-A-8300409 is thus to be considered as comprised in the state of the art in accordance with Article 54(3) EPC in respect of the subject matter of the first and second Japanese patent applications from which the present application claims priority, and as comprised in the state of the art in accordance with Article 54(2) EPC in respect of the subject matter of the remaining four Japanese applications from which the present application claims priority. Disclosed in W0-A-8300409 are solar cells and arrays of solar cells made as thin films on insulating substrates. In a first embodiment configured as an individual photoelectric conversion device, by use of masking techniques a thin conductive film is deposited on a glass substrate, a semiconductor film incorporating a P-N junction is deposited on top of the conductive film, a second conductive film is deposited on top of the semiconductor film, and contacts are made to edges of the conductive films. In a second embodiment, an array of such cells is made by shifting the mask between successive deposition steps so that an edge of the second conductive film of one cell overlaps an edge of the first conductive film of an adjacent cell for connecting the cells in series. Mention is made in W0-A-8300409 of forming one or other of the conductive films as discrete films of ITO (indium-tin oxide) and gold.

### SUMMARY OF THE INVENTION

It is therefore an object of the present invention to provide a novel photoelectric conversion device which is free from the abovesaid defects.

In accordance with one aspect of the present invention there is provided a photoelectric conversion device comprising, as in one or more of the above described prior art devices:
a substrate having an insulating surface; and
a plurality of semiconductor elements U₁ to Uₙ, n being an integer larger than one, formed thereon in side by side relationship and connected sequentially in series with one another;
the semiconductor element U₁, i=1, 2,...n, comprising a first electrode Eᵢ formed on the substrate, a silicon based non-single-crystal semiconductor laminate member Qᵢ formed on the first electrode Eᵢ and having formed therein at least one PN or PIN junction, and a second electrode Fᵢ formed on the non-single-crystal semiconductor laminate member Qᵢ in opposing relationship to the first electrode Eᵢ; the first electrode E₁ to Eₙ being separated from one another by first grooves G₁ to Gₙ₋₁;
the second electrodes F₁ to Fₙ being separated from one another by isolating portions H₁ to Hₙ₋₁; and
the second electrode Fⱼ₊₁, j=1,2... (n-1), of the semiconductor element Uⱼ₊₁ being coupled with the first electrode Eⱼ of the semiconductor element Uⱼ through a coupling portion Kⱼ consisting of an integrally formed extension of the second electrode Fⱼ₊₁, said coupling portion Kⱼ being located at a position where a portion of the second electrode Fⱼ₊₁ extends on the non-single-crystal semiconductor laminated member Qⱼ opposite to a portion of the first electrode Eⱼ and passing through a second groove Oⱼ provided between at least portions of the non-single-crystal semiconductor laminate members Qⱼ and Qⱼ₊₁ to separate said members and to expose the first electrode Eⱼ;
characterized in that:
the second electrode Fᵢ and the coupling portion Kⱼ consists of a multi-layered member including a conductive metal oxide layer making contact with the non-single-crystal semiconductor laminate member Qᵢ and a further conductive material layer formed on the said metal oxide layer.

Since the oxide which forms the metal oxide layer of the second electrode Fᵢ contacting the non-single-crystal semiconductor laminate member Qᵢ is stable chemically, the metal oxide layer is not degraded by long-term use of the device and does not react with the non-single-crystal semiconductor laminate member Qᵢ. This ensures that good contact is maintained between the non-single-crystal semiconductor laminate member Qᵢ and the second electrode Fᵢ and ensures that the characteristics of the non-single-crystal semiconductor laminate member Qᵢ remain stable without deterioration for a long period of time.

Accordingly, it is possible with the photoelectric conversion device of the present invention to obtain high photoelectric conversion efficiency.

The further conductive layer of electrode Fᵢ can be made reflective so that light incident on the second electrode Fᵢ after passing through the non-single-crystal semiconductor laminate member from the substrate side of the device can be reflected back to the non-single-crystal semiconductor laminate member Qᵢ. This improves the efficiency of utilization of light.

Accordingly, the photoelectric conversion device of the present invention is capable of providing high photoelectric conversion efficiency for a long period of time.

Alternatively, by forming the conductive layer of the second electrode Fⱼ₊₁ of a sublimable metal, the electrical insulation between the second electrodes Fⱼ and Fⱼ₊₁ can be held high. The reason for this is that when the second electrode Fⱼ₊₁ is formed by laser beam scanning of a conductive layer having a metal oxide layer and a sublimable metal layer formed thereon according to a manufacturing method of the present invention described later, the metal forming the sublimable metal layer does not enter into the non-single-crystal semiconductor laminate member Qⱼ.

Accordingly, high photoelectric conversion efficiency can be obtained with the photoelectric conversion device of the present invention.

As will be described hereinafter, the photoelectric conversion device of the present invention can be formed by a process including the following steps (a) to (d):
(a) a first conductive layer, which will ultimately serve as a first electrode of each semiconductor element, is formed on the substrate and the first conductive layer is subjected to first scanning by a laser beam, thereby providing the first electrode of each semiconductor element;
(b) a non-single-crystal semiconductor laminate member which will ultimately serve as a non-single-crystal semiconductor laminate member of each semiconductor element having formed therein at least one semiconductor junction is formed on the substrate in such a manner as to cover the first electrode of each semiconductor element, providing the non-single-crystal semiconductor laminate member thereof;
(c) the non-single-crystal semiconductor of the semiconductor elements are subjected to second scanning by a laser beam, thereby cutting therein grooves to expose the first electrodes;
(d) a second conductive layer, which is a multi-layered structure including a conductive metal oxide layer and a further conductive layer and which will ultimately serve as a second electrode of each semiconductor element, is formed to extend on the non-single-crystal semiconductor laminate members and in the grooves, and then the second conductive layer is subjected to third scanning by a laser beam, thereby providing the second electrode of each semiconductor element.

According to the manufacturing method including the abovesaid steps, the second electrode of each semiconductor element includes a conductive metal oxide layer in contact with the non-single-crystal semiconductor laminate member, so that the second electrode is formed to make good contact with the non-single-crystal semiconductor laminate member. Further, in the case where the further conductive layer of the second electrode is a reflective conductive layer, light incident thereon from the substrate side of the device will be reflected back into the semiconductor laminate member. Accordingly, it is possible to manufacture a photoelectric conversion device of high photoelectric conversion efficiency. Alternatively if the further conductive layer is sublimable, the second electrode can easily be formed by laser beam scanning of the second conductive layer with high precision. Accordingly, the photoelectric conversion device can be manufactured with ease.

Therefore, in accordance with another aspect of the present invention there is provided a method of making a photoelectric conversion device which, as in one or more of the prior art devices aforementioned comprises the steps of:
forming a first electrically conductive electrode layer on a substrate having an insulating surface;
selectively removing said first electrode layer by laser beam scanning, to form therein (n-1), wherein n is an integer larger than 2, sequentially arranged first grooves G₁ to Gₙ₋₁ defining n sequentially arranged first electrodes E₁ to Eₙ separated by the first grooves G₁ to Gₙ₋₁, respectively;
forming a continuous silicon based non-single-crystal semiconductor laminate layer having at least on PN or PIN junction over the first grooves G₁ to Gₙ₋₁ and the electrodes E₁ to Eₙ;
selectively removing said non-single-crystal semiconductor laminate layer by laser beam scanning to form therein n-1 sequentially arranged second grooves 0₁ to 0ₙ₋₁ extending therethrough to expose the first electrodes E₁ to Eₙ₋₁ and define n semiconductor laminate members Q₁ to Qₙ each associated with a respective one of the electrodes E₁ to Eₙ;
forming a second electrically conductive electrode layer which extends continuously over the non-single-crystal semiconductor laminate members Q₁ to Qₙ and into the grooves 0₁ to 0ₙ₋₁ to define coupling portions K₁ to Kₙ₋₁ which are connected to the first electrodes E₁ to Eₙ₋₁ through the grooves 0₁ to 0ₙ₋₁; and
selectively removing said second electrode layer by laser beam scanning to form therein isolating portions H₁ to Hₙ₋₁ located on the non-single-crystal semiconductor laminate members Q₁ to Qₙ, respectively, the second electrodes F₂ to Fₙ being connected to the first electrodes E₁ to Eₙ₋₁ through the coupling portions K₁ to Kₙ₋₁, respectively:
characterized in that:
said second electrode layer is formed as a multi-layer comprising a conductive metal oxide layer in contact with said semiconductor laminate members Q₁ to Qₙ and a further conductive layer overlying said metal oxide layer, said further conductive layer consisting of a sublimable metal.

Other features of the present invention are set forth in the appended claims and will become more fully apparent from consideration of the following detailed description taken in conjunction with the accompanying drawings.

### BRIEF DESCRIPTION OF THE DRAWINGS

Fig.1 is a plan view schematically illustrating an embodiment of the present invention;
Fig.2 is a schematic sectional view taken on the line II-II in Fig.1;
Figs. 3A and 3B are detailed cross-sectional views showing on an enlarged scale parts of the embodiment of the present invention shown schematically in Fig. 2;
Figs. 4A and B are detailed sectional views showing on an enlarged scale other parts of the embodiment of Fig. 1;
Figs. 5A to G are cross-sectional views schematically showing some of the sequential steps involved in the manufacture of the photoelectric conversion device of the embodiment of the present invention depicted in Figs. 1 to 4;
Figs. 6A to D, 7A to E and 8 are schematic cross-sectional views, similar to Fig. 3, illustrating other embodiments of the present invention, respectively;
Fig. 9 is a plan view schematically illustrating another embodiment of the present invention;
Fig. 10 is a schematic cross-sectional view taken on the line X-X in Fig. 9;
Fig. 11 is an enlarged cross-sectional view showing a part of the photoelectric conversion device of the present invention illustrated in Figs. 9 and 10; and
Fig. 12 is a schematic cross-sectional view showing a sequence steps involved in the manufacture of the photoelectric conversion device depicted in Fig. 9 and 10.

### DESCRIPTION OF THE PREFERRED EMBODIMENTS

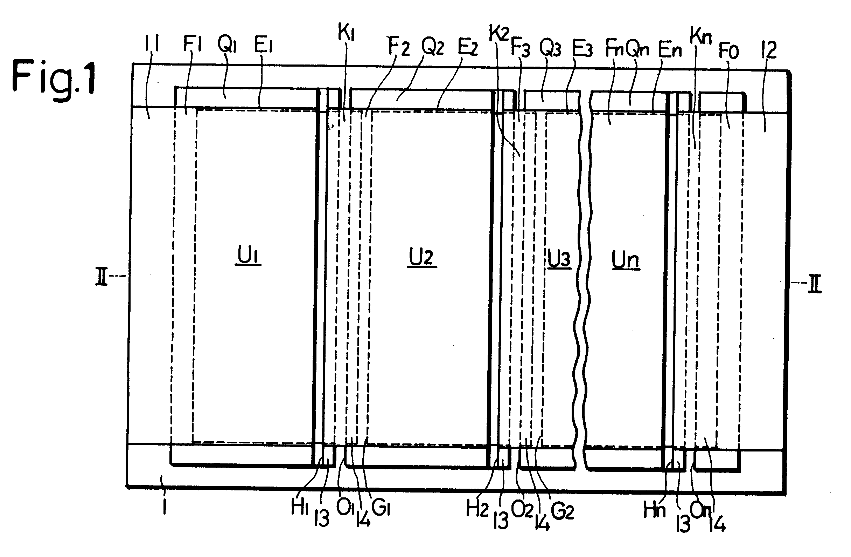

A description will be given first, with reference to Figs. 1 to 3, of an embodiment of the present invention.

The embodiment of the photoelectric conversiodn device of the present invention shown in Figs. 1 to 3 has a plurality n (n being an integer larger than one) of photo semiconductor elements U₁ to Uₙ formed side by side on a substrate 1.

The substrate 1 has an insulating surface 2.

The substrate 1 may be a light-transparent substrate made of glass, organic synthetic resin or the like, or a flexible sheet as of organic synthetic resin. It is also possible to employ a non-light-transparent substrate of ceramics, organic resin or the like, a non-light-transparent metal substrate having its surface insulated, or a flexible, insulating sheet-like member having an insulating film formed on the surface of a flexible metallic sheet. The substrate 1 is, for example, rectangular in shape and 20 cm wide and 60 cm long.

In the case of the substrate 1 being the abovesaid,flexible metallic sheet-like member, it is made, for instance, of aluminum or an aluminum-base alloy and has a thickness of, for example, 10 to 200 µm, preferably, 50 to 150 µm.

The insulating film formed on the surface of the flexible metallic sheet-like member is, for example, an oxide film resulting from oxidation of the surface of the sheet-like member. When the flexible metallic sheet-like member is made of aluminum or an aluminum-base alloy, the abovesaid oxide film is an aluminum oxide (alumina Al₂O₃) or an insulating material consisting principally of the aluminum oxide. The oxide film has a thickness small enough not to impair the flexibility of the flexible metallic sheet-like member, for instance, in the range of 0.1 to 2 µm, preferably, 0.3 to 1 µm. Such an oxide film can be formed by calorizing the flexible metallic sheet-like member made of aluminum or the aluminum-base alloy.

The photo semiconductor element Uᵢ (i=1, 2, ....n) on the substrate 1 has an electrode Eᵢ formed on the substrate 1, a non-single-crystal semiconductor laminate member Qᵢ formed on the electrode Eᵢ and an electrode Fᵢ formed on the non-single-crystal semiconductor laminate member Qᵢ in opposing relation to the electrode Eᵢ.

The electrode Eᵢ is, for example, rectangular in shape and has a width of 5 to 40 mm, preferably 15 mm and a length slightly smaller than the length of the substrate 1.

Electrodes Eⱼ(j=1, 2, ...(n-1)) and Eⱼ₊₁ are spaced apart by a groove Gⱼ which is shown to extend in the vertical direction in Fig. 1. The groove Gⱼ is, for example, 40 µm wide.

The electrode Eᵢ may be a single-layer structure as shown in Fig. 3A.

The electrode Eᵢ may also be a two-layer structure which comprises a layer 4 making contact with the substrate 1 and a layer 5 formed on the layer 4 in contact with the non-single-crystal semiconductor laminate member Qᵢ as shown in Figs. 3C and D. Also it is possible to employ a three-layer structure having another layer sandwiched between the layers 4 and 5 though not shown.

The electrode Eᵢ may be a reflective electrode when the electrode Fᵢ is light-transparent. When the electrode Eᵢ is the reflective electrode, light incident on the non-single-crystal semiconductor laminate member Qᵢ on the opposite side from the substrate 1 passes through the non-single-crystal semiconductor laminate member Qᵢ, then is reflected by the surface of the electrode Eᵢ back to the non-single-crystal semiconductor laminate member Qᵢ to pass therethrough. The larger the optical path length of the reflected light in the non-single-crystal semiconductor laminate member Qᵢ is, the more the utilization efficiency of light is raised. From this point of view, it is preferable that the surface of the electrode Eᵢ on the side of the non-single-crystal semiconductor laminate member Qᵢ have irregularities oblique to planes perpendicular to the substrate surface to form a diffuse reflection surface 6 at the boundary between it and the non-single-crystal semiconductor laminate member Qᵢ.

In the case where the electrode Eᵢ is reflective, it may be of a single-layer structure formed by a reflective conductive layer.

In this case, the layer may be one that is formed of aluminum or silicon, or consisting principally thereof. In the case where the electrode Eᵢ is a reflective electrode and has the two-layer structure comprised of the layers 4 and 5, in order to simultaneously satisfy the requirements that the electrode Eᵢ be of high conductivity and high reflectivity and to prevent that when the non-single-crystal semiconductor laminate member Qᵢ is formed, the material of its non-single-crystal semiconductor layer on the side of the electrode Eᵢ or an impurity contained therein reacts with the material of the reflective electrode to form a layer of high contact resistance in the interface between the electrode Eᵢ and the non-single-crystal semiconductor layer Qᵢ, it is preferable that the layer 4 be a reflective conductive layer and the layer 5 a light transparent metal oxide layer 5.

In the case where the layer 4 of the electrode Eᵢ is the reflective conductive layer, it may preferably be made of metal. The metal may be stainless steel but, in view of the requirements of high conductivity and high reflectivity for the electrode Eᵢ, it is preferable to employ aluminum (Al), silver (Ag), an aluminum-base alloy containing, for example, 0.1 to 2 volume% of silicon, or a silver-base alloy.

When the layer 5 of the electrode Eᵢ is a light-transparent metal oxide layer, in order to ensure that the layer 5 be high in conductivity and in transmittance and to prevent that when the non-single-crystal semiconductor laminate layer Qᵢ is formed, the metallic oxide reacts with the material or impurity of the non-single-crystal semiconductor layer of the laminate member Qᵢ on the side of the electrode Eᵢ to form the abovesaid high contact resistance layer, it is preferable to form the layer 5 of a tin oxide (SnO₂ or SnO) or a metallic oxide consisting principally of such a tin oxide, for instance, a tin oxide containing halogen or, 1 to 10 wt% of antimony oxide in the event that the non-single-crystal semiconductor layer of the non-single-crystal semiconductor laminate member Qᵢ on the side of the electrode Eᵢ is p-type. In the case where the layer of the non-single-crystal semiconductor laminate member Qᵢ on the side of the electrode Eᵢ is N-type, it is preferable to use an indium oxide or a metallic oxide consisting principally of thereof, for instance, an indium oxide containing 1 to 10 wt% of tin oxide. In this case, the light transparent conductive layer 5 is 300 to 600 A thick.

In the case where the electrode Eᵢ is such a two-layer reflective electrode comprising the layer 4 and the layer 5, when the abovesaid diffuse reflection surface 6 is formed at the boundary between the electrode Eᵢ and the non-single-crystal semiconductor laminate member Qᵢ, it is formed on the surface of the layer 5 on the side of the laminate member Qᵢ.

In the case where the electrode Eᵢ is comprised of the layers 4 and 5 these layers are a reflective conductive layer and a light-transparent conductive layer to form a reflective electrode, the surface of the layer 4 may also be formed as the diffuse reflection surface in the interface between it and the light-transparent conductive layer 5, through not shown.

When the substrate 1 is light-transparent, the electrode Eᵢ is formed as a light-transparent electrode.

In such a case, the light-transparent electrode may be a metal oxide layer.

Where the electrode Eᵢ is a single-layer light-transparent electrode, when the non-single-crystal semiconductor layer of the non-single-crystal laminate member Qᵢ on the side of the electrode Eᵢ is P-type, the electrode Eᵢ may preferably of a tin oxide or consisting principally thereof for the same reasons as given previously.

When the abovesaid non-single-crystal semiconductor layer is N-type, the electrode Eᵢ may preferably be a metal oxide layer formed of an indium oxide or consisting principally thereof.

In the case where the electrode Eᵢ has the two-layer structure comprised of the layers 4 and 5 and is light-transparent, if the non-single-crystal semiconductor layer of the non-single-crystal semiconductor laminate member Qᵢ on the side of the electrode Eᵢ is P-type, it is preferable that the layer 5 be a metal oxide layer formed of a tin oxide or consisting principally thereof and the layer 4 a metal oxide layer formed of an indium oxide or consisting principally thereof.

When the electrode Fᵢ is light-transparent, the electrode Eᵢ need not always be reflective. In this case, if the electrode Eᵢ is single-layer, it may be a layer formed of chrominum or consisting principally thereof. Moreover, in the case of the two-layer structure, the layer 4 may be the abovesaid metal oxide layer and the layer 5 may be layer formed of chrominum or consisting principally thereof.

In the semiconductor element Uᵢ formed on the substrate 1, the non-single-crystal semiconductor laminate member Qⱼ₊₁ (j=1, 2,...(n-1)) on the aforesaid electrode Eⱼ₊₁ extends laterally from the marginal edge of the electrode Eⱼ₊₁ on the opposite side from the electrode Eⱼ to a position on the electrode Eⱼ on the side of the electrode Eⱼ₊₁ across the groove Gⱼ separating the electrode Eⱼ and Eⱼ₊₁ making contact with the non-single-crystal semiconductor laminate member Qⱼ.

The non-single-crystal semiconductor laminate member Q₁ formed on the electrode E₁ extends laterally onto the substrate 1 to cover the side surface of the electrode E₁ on the opposite side from the electrode E₂.

Further, laminate member Qₙ is formed as a non-single-crystal-semiconductor laminate member Q₀ to laterally extend onto the substrate 1 to cover the side surface of the electrode Eₙ on the opposite side from the electrode Eₙ₋₁.

The non-single-crystal semiconductor laminate member Qᵢ is formed to vertically extend to cover the electrode Eᵢ. The non-single-crystal semiconductor laminate member Qᵢ has cut therein a groove Oᵢ which is shown to extend in the vertical direction in Fig. 1. The grooves O₁ to Oₙ are formed simultaneously.

The non-single-crystal semiconductor laminate member Qᵢ formed on the electrode Eᵢ may be formed by one or more such two-layer structures, each composed of a P-type or N-type non-single-crystal semiconductor layer and another non-single-crystal semiconductor layer of the opposite conductivity type.

Accordingly, the non-single-crystal semiconductor laminate member Qᵢ can be formed to have at least one PN junction.

Furthermore, the non-single-crystal semiconductor laminate member Qᵢ may preferably be formed by one or more three-layer structures, each composed of a P-type or N-type non-single-crystal semiconductor layer 8, an I-type non-single-crystal semiconductor layer 9 and a non-single-crystal semiconductor layer 10 opposite in conductivity type to the layer 8 as shown in Fig. 3. Accordingly, the non-single-crystal semiconductor laminate member Qᵢ may preferably be formed to have at least one PIN junction.

The non-single-crystal semiconductor layer of the non-single-crystal semiconductor laminate member Qᵢ on the side of the electrode Eᵢ is P-type when the layer of the electrode Eᵢ making contact with the non-single-crystal semiconductor laminate member Qᵢ is formed by a tin oxide or metallic oxide consisting princiipally of the tin oxide as described previously in respect of Fig. 3. When the layer 5 of the electrode Eᵢ making contact with the non-single-crystal semiconductor laminate member Qᵢ is formed by an indium oxide or metallic oxide consisting principally of the indium oxide, the non-single-crystal semiconductor layer of the non-single-crystal semiconductor laminate member Qᵢ on the side of the electrode Eᵢ is N-type.

Accordingly, in the case where the non-single-crystal semiconductor laminate member Qᵢ has the three-layer structure comprising the non-single-crystal semiconductor layers 8, 9 and 10 as illustrated in Fig. 3 and the layer of the electrode Eᵢ semiconductor laminate member Qᵢ is formed by the tin oxide or metallic oxide consisting principally of the tin oxide, the non-single-crystal semiconductor layers 8 and 10 are P-type and N-type, respectively. When the light transparent conductive layer 5 is formed by the indium oxide or metal oxide consisting principally of indium oxide, the non-single-crystal semiconductor layers 8 and 10 are N-type and P-type, respectively.

The non-single-crystal semiconductor layers making up the non-single-crystal semiconductor laminate member Qᵢ may preferably be formed of silicon or a semiconductor consisting principally of silicon.

When the non-single-crystal semiconductor laminate member Qᵢ has the three-layer structure composed of the non-single-crystal semicodnuctor layers 8, 9 and 10, the non-single-crystal semicodncutor layer 8 may be formed, for instance, of silicon to a thickness of 5 to 300 A, preferably 70 to 130 A. Where the non-single-crystal semiconductor layer 8 is P-type, for example, boron (B) may be introduced thereinto as a P-type impurity.

The non-single-crystal semiconductor layer 9 can be formed of silicon as is the case with the non-single-crystal semiconductor layer 8 but its thickness may preferably be larger than that of the layer 8, for instance, 0.4 to 0.7 µm. The non-single-crystal semiconductor layer 9 contains a very small amount of a P-type impurity or does not substantially contain either of P-type and N-type impurities and, if any, their concentrations are negligibly low.

The non-single-crystal semiconductor layer 10 can also be formed of silicon as is the case with the non-single-crystal semiconductor layer 8. But since the non-single-crystal semiconductor layer 10 is disposed on the side where the light to be converted is incident on the semiconductor element, it may preferably be formed of a semiconductor which has a larger energy band gap than does the semiconductor material of the non-single-crystal semiconductor layer 8, such as, for example, silicon carbide expressed by SiₓC₁₋ₓ (0 < x < 1). In this case, the non-single-crystal semiconductor layer 10 can be formed to a thickness of 5 to 300 A, typically, in the range of 7 to 130 A.

Incidentally, the aforesaid non-single-crystal semiconductor laminate member Q₀ has the same structure as the aforementioned one Qᵢ.

In the semiconductor element Uᵢ formed on the substrate 1, the electrode Fᵢ on the non-single-crystal semiconductor laminate member Qᵢ is disposed opposite to the electrode Eᵢ formed on the non-single-crystal semiconductor laminate member Qᵢ.

In this case, the electrode Fⱼ₊₁ extends from a position apart from the isolated end portion of the non-single-crystal semiconductor laminate member Qⱼ₊₁ on the opposite side from the non-single-crystal semiconductor laminate member Qⱼ onto its isolated end portion on the side of the non-single-crystal semiconductor laminate member Qⱼ₊₁.

The electrode Fᵢ extends from a position away from the isolated end portion of the non-single-crystal laminate member Q₁ on the side of the non-single-crystal semiconductor laminate member Q₂ to the marginal edge of the substrate 1 to cover the extension of the non-single-crystal laminate member Q₁ on the side surface of the electrode E₁.

On the non-single-crystal semiconductor laminate member Qₙ, an electrode F_{O} similar to the electrode Fₙ is formed to extend from the isolated end portion on the side of the non-single-crystal semiconductor laminate member Q_{O} to the marginal edge of the substrate 1 to cover the side surface of the non-single-crystal semiconductor laminate member Q_{O}.

The electrodes Fⱼ and Fⱼ₊₁ are isolated by an isolating portion Hⱼ. The electrodes Fⱼ₊₁ and F_{O} are also isolated by an isolating portion Hₙ. The isolating portions Hᵢ may be simultaneously formed as grooves as is the case with the grooves Gᵢ.

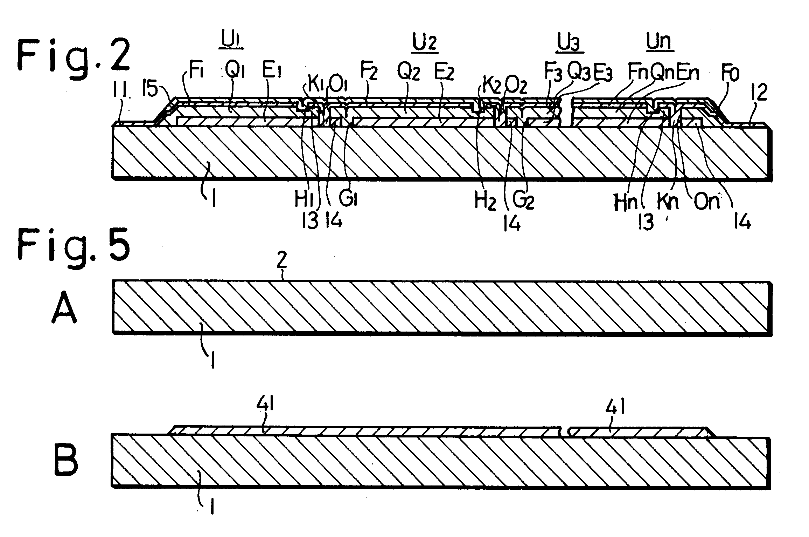

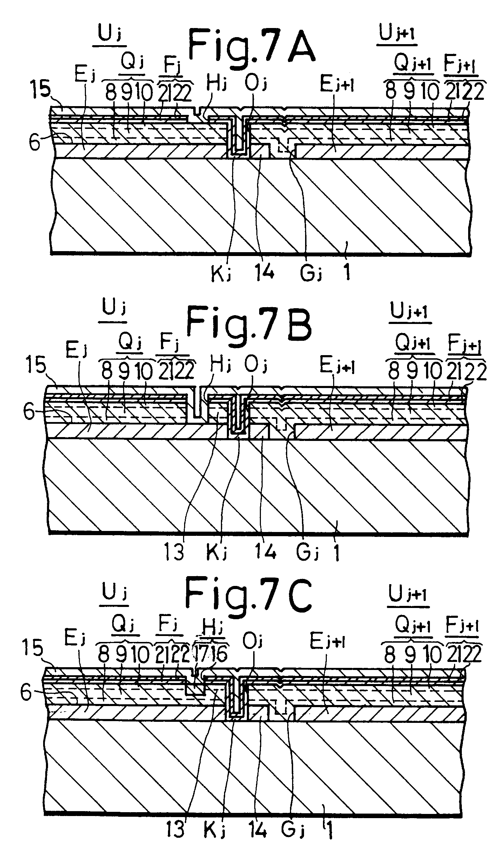

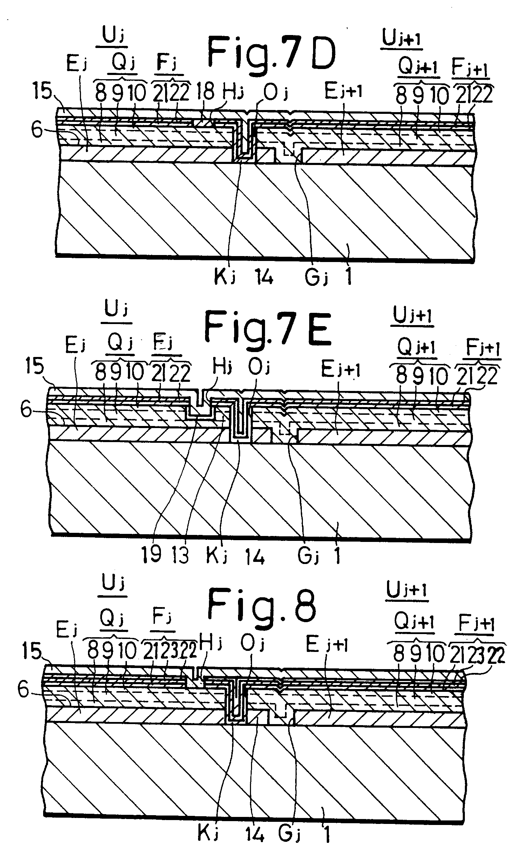

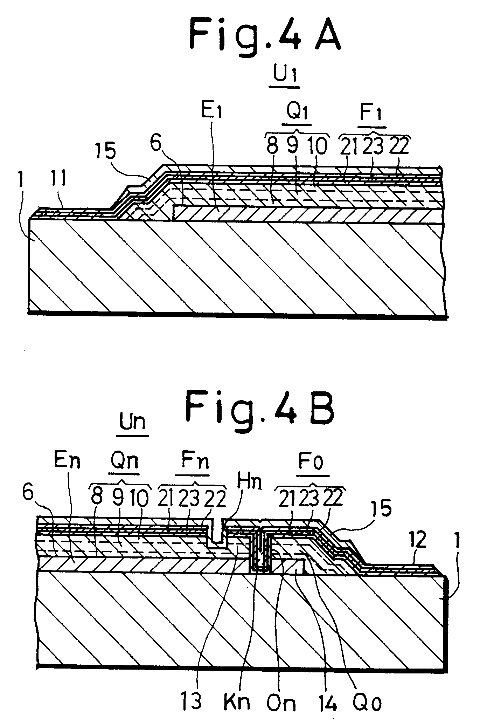

The electrode Fᵢ is shown as a single layer in Fig. 2 for the sake of simplicity, but in accordance with the teachings of the present invention is actually a multi-layer structure comprised of a layer 21 making contact with the non-single-crystal semiconductor laminate member Qᵢ and a layer 22 formed on the layer 21 as illustrated in Figs. 3 A and 3B and Figs. 7A to 7E, for example, or comprised of the layers 21 and 22 and another layer 23 as depicted in Fig.8.

The layer 21 of the electrode Fᵢ is formed of a conductive metallic oxide and, in the case where the electrode Fᵢ is transparent, it is required that the metal oxide be high in both conductivity and in transmittance and, when forming the electrode Fᵢ, would not react with the material or impurity of the non-single-crystal semiconductor layer of the non-single-crystal semiconductor laminate member Qᵢ on the side of the electrode Fᵢ to form a layer which would increase the contact resistance between the non-single-crystal semiconductor laminate member Qᵢ and the electrode Fᵢ or a layer of low transmittance. To meet such requirements, when the non-single-crystal layer of the non-single-crystal semiconductor laminate member Qᵢ on the side of the electrode Fᵢ is N-type, the layer 21 of electrode Fᵢ may preferably be formed of an indium oxide or a metallic oxide consisting principally of indium oxide, such as, for example, an indium oxide containing 1 to 10 wt% of tin oxide. When the non single crystal layer of the non-single-crystal semiconductor laminate layer Qᵢ on the side of the electrode Fᵢ is P-type, the layer 21 of electrode Fᵢ may preferably be formed of a tin oxide or a metallic oxide consisting principally of tin oxide.

When the layer 21 is formed of tin oxide or consists principally thereof, the layer 22 can be formed of indium oxide or can consist principally thereof and, when the layer 21 is formed of indium oxide or consists principally thereof, the layer 22 can be formed of tin oxide or can consist principally thereof.

The electrode Fᵢ can also be reflective when the substrate 1 and the electrode Eᵢ are light-transparent. When the electrode Fᵢ is reflective, and is a two-layer structure made up of the layers 21 and 22, it is preferred that depending on whether the non-single-crystal semiconductor layer of the non-single-crystal semiconductor laminate member Qᵢ contacting the layer 21 is P-type or N-type, the layer 21 be formed of tin oxide or consist principally thereof or alternatively be formed of indium oxide or consist principally thereof, and in this case the layer 22 can be a reflective conductive layer of silver or aluminum for example, as described previously.

When the elctrode Fᵢ is reflective and has the three-layer structure composed of the layers 21, 22 and 23, it is preferable that the layers 21 and 22 be such layers as mentioned above and the layer 23 a nickel layer.

The electrode Fᵢ need not always be reflective even if the substrate 1 and the electrode Eᵢ are light-transparent. In such a case, if the electrode has the two-layer structure comprised of the layers 21 and 22, it is preferred that the layer 21 be such a layer as mentioned above and the layer 22 a sublimable conductive layer formed of chromium or consisting principally thereof.

The electrode F_{O} formed to extend on the non-single-crystal semiconductor laminate member Q₀ has the same structure as the abovesaid electrode Fᵢ.

The electrode Fⱼ₊₁ of the semiconductor element Uⱼ₊₁ (j=1, 2, ...(n-1)) is coupled with the electrode Eⱼ of the semoconductor element Uⱼ through a coupling portion Kⱼ.

The coupling portion Kⱼ extends from the position where the electrode Fⱼ₊₁ is opposite to the electrode Eⱼ to the region of the electrode Eⱼ opposite to the electrode Fⱼ₊₁, passing through a groove Oⱼ by which the non-single-crystal semiconductor laminate members Qⱼ and Qⱼ₊₁ are separated. Such a coupling portion Kⱼ is formed by an extension of the electrode Fⱼ₊₁ formed simultaneously with the electrode Fⱼ₊₁.

The electrode F₁ of the semiconductor element U₁ extends down to the surface of the substrate 1 as referred to previously and the extension constitutes an external connection terminal 11.

The electrode F₀ extending on the non-single-crystal semiconductor laminate member Q₀ is coupled with the electrode Eₙ of the semiconductor element Uₙ through a coupling portion Kₙ. In this case, the coupling portion Kₙ extends from the position where the electrode F₀ is opposite to the electrode Eₙ to the region of the electrode Eₙ opposite to the electrode F₀, passing through a groove Oₙ. Such a coupling portion Kₙ is an extension of the electrode F₀ formed simultaneously therewith. The electrode F₀ extends on the side surface of the non-single-crystal semiconductor laminate member Q₀ in the direction reverse from the electrode Fₙ to the marginal edge of the substrate 1, and the extending end portion forms a terminal 12 for external connection.

The isolated portion Hⱼ is formed to extend in the vertical direction in Fig. 1 to go down into the non-single-crystal semiconductor laminate member Qⱼ to form therein a region 13 underlying the electrode Eⱼ₊₁. The groove Oⱼ also extends across that portion of the electrode Eⱼ adjacent to the electrode Eⱼ₊₁ in the thickwise direction. Accordingly, the electrode Eⱼ has an isolated portion 14 on the side of the electrode Eⱼ₊₁.

The isolated portion Hₙ is formed to extend in the vertical direction in Fig. 1 to go down into the non-single-crystal semiconductor laminate member Qₙ to form therein the region 13 underlying the electrode F₀.

The groove Oₙ extends across that portion of the electrode Eₙ opposite side from the electrode F₀ in the thickwise direction. Accordingly, the electrode Eₙ has the isolated region 14 on the opposite side from the electrode Eₙ₋₁.

On the substrate 1 is formed a transparent antireflection and protective film 15 to cover the aforesaid semiconductors U₁ to Uₙ. In this case, however, the antireflection and protective film 15 does not extend on the extended portions of the electrodes F₁ and F₀ forming the aforementioned external connection terminals 11 and 12, respectively.

The foregoing is a description of the arrangement of an embodiment of the photoelectric conversion device according to the present invention.

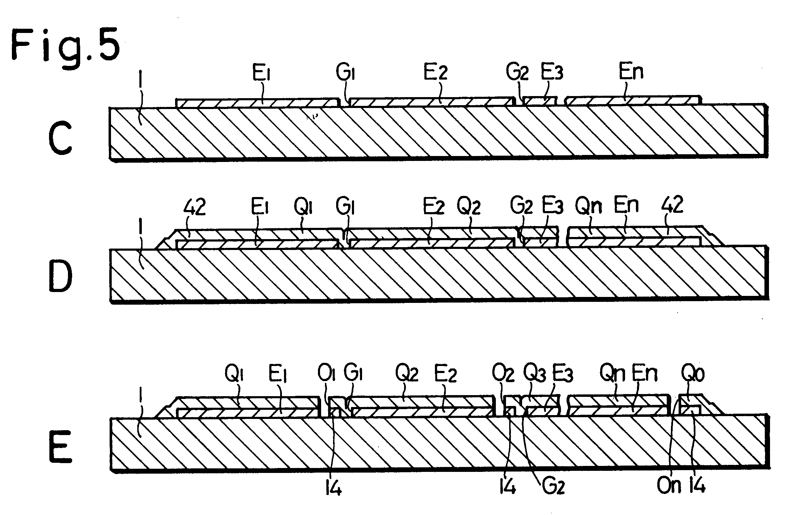

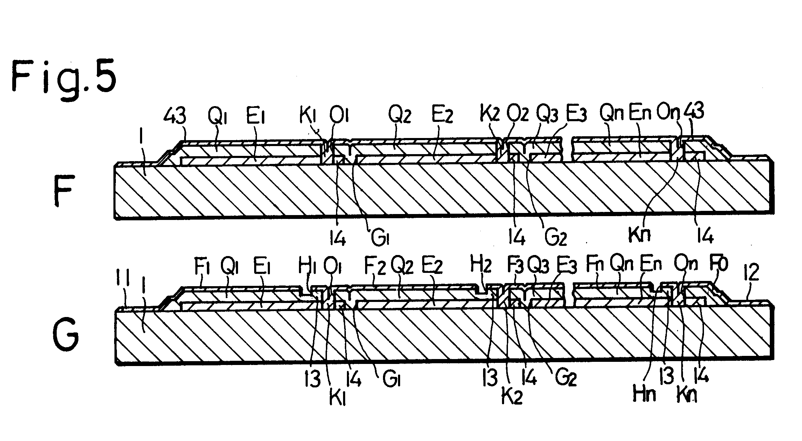

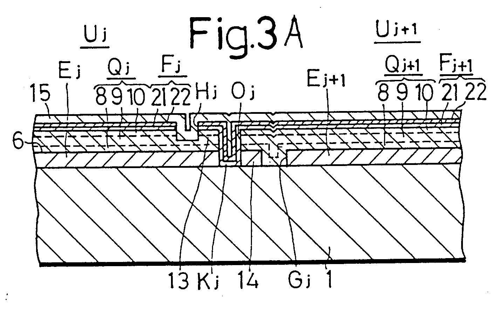

Next, a description will be given, with reference to Figs. 5A to G, of sequential steps included in an exemplary method of manufacturing a photoelectric conversion device as described in the foregoing.

In Figs. 5A to 5G, parts corresponding to those in Figs. 1 and 2 are identified by the same reference numerals and characters and no detailed description thereof will be repeated.

The manufacturing method of the photoelectric conversion device shown in Figs. 5A to 5G is as follows:
The manufacture starts with the preparation of such a substrate 1 as described previously in respect of Figs. 1 and 2.

Then, as shown in Fig. 5B, the conductive layer 41 which will ultimately form the electrodes E₁ to Eₙ described previously in connection with Figs. 1 and 2 is formed by a known method on the substrate 1.

In the case where the electrodes E₁ to Eₙ are each formed to have the two-layer structure composed of the two layers 4 and 5 as described previously with regard to Fig. 3B,the conductive layer 41 is made up of a layer which will ultimately serve as the layer 4 and another layer which ultimately serve as the layer 5, though neither shown nor described in detail. The former layer is first formed on the substrate 1 by a known method, for example, vapor deposition and then the latter layer is similarly formed thereon by a known method, for instance, vapor deposition. Next, the conductive layer 41 is scanned by a laser beam (not shown) having a diameter of 30 to 70 µm, typically, 40 µm, by which the aforementioned (n-1) grooves Gᵢ to Gₙ₋₁ are cut in the conductive layer 41 to form n electrodes E₁ to Eₙ which are separated from adjacent ones of them by the grooves G₁ to Gₙ₋₁, as shown in Fig. 5C. For this scanning, it is possible to employ a laser beam of a 1.06 µm wavelength from a YAG laser and a laser beam of a 0.488 or 0.512 µm wavelength from an argon laser.

The abovesaid laser beam scanning can be carried out in the air but may also be performed in the atmosphere of a gas which reacts with the conductive material of the layer 41 at high temperatures to spatter it from the substrate surface. In this case, the gas used may be hydrogen fluride (HF), hydrogen chloride (HCl) or Freon (Freon is a Registered Trade Mark RTM) gas (CF₄, CHF₃, CClF₃ and like gases). In the case where the laser beam scanning takes place in the air, burrs are likely to form on the upper marginal edges of the groove Gⱼ. Accordingly, it is desirable that the laser beam scanning be followed by deburring through the use of the abovesaid gas or etching with an etchant such as hydrofluoric acid (HF), hydrochloric acid (HCl) or Freon (RTM) liquids C₂F₃Cl₄ and similar liquids. Moreover, it is possible to accomplish the laser beam scanning of the conductive layer 41 easily and accurately by the aid of a computer while monitoring through a video camera device.

Next, a non-single-crystal semiconductor layer formed by a known method, for example, low-pressure CVD on the substrate 1 to fill the grooves G₁ to Gₙ₋₁ and to cover the electrode E₁ to Eₙ as shown in Fig. 5D so that the regions of the layer 42 on the electrodes E₁ to Eₙ may be the non-single-crystal semiconductor laminate members Q₁ to Qₙ described previously in respect of Figs. 1 and 2.

Where the non-single-crystal semiconductor laminate members Q₁ to Qₙ are each formed as the three-layer structure consisting of the non-single-crystal semiconductor layers 8, 9 and 10 as described previously with regard to Figs. 3A and 3B, non-single-crystal semiconductor layers which will ultimately be used as the non-single-crystal layers 8, 9 and 10 respectively, are formed in this order through the use of a known method, for instance, the low-pressure CVD method, thereby providing the non-single-crystal semiconductor laminate member 42.

After this, the non-single-crystal semiconductor laminate members Q₁ to Qₙ are selectively removed by laser beam scanning to cut therein the aforementioned n grooves O₁ to Oₙ as shown in Fig. 5E. In this case, the groove Oᵢ (i=1, 2, ...n) can be formed to extend down to the insulating film 2 of the substrate 1 across the electrode Eᵢ as illustrated. In such a case, the region 14 of the electrode Eᵢ is isolated from the other regions. The laser beam scanning of the non-single-crystal semicondcutor laminate members Q₁ to Qₙ can take place in the air as is the case with the conductive layer 41. It is also possible to carry out the laser beam scanning in the atmosphere of a gas which reacts with the materials of the non-single-crystal semiconductor laminate member 42 and the electrodes E₁ to Eₙ at high temperatures to spatter them from the substrate surface. Also in this case, the gas used is hydrogen fluoride, hydrogen chloride or Freon (RTM) gas. In the case where the laser beam scanning of the non-single-crystal semiconductor laminate members Q₁ to Qₙ is carried out in the air, it is desirable that the laser beam scanning be followed by deburring through the use of the aforesaid gas or etching with such etchants as mentioned previously. The abovesaid laser beam scanning can also be performed easily and accurately by the aid of a computer while monitoring through the video camera device.

The groove Oⱼ (j=1, 2, ...(n-1)) is formed at a position spaced a predetermined distance apart from the groove Gⱼ laterally thereof (on the left thereof in Fig. 5E). The abovesaid predetermined distance is large as compared with the thickness of the non-single-crystal semiconductor laminate member 42. It is preferable, however, to minimize this distance. By the aid of a computer the groove Oⱼ can be provided in close proximity to the groove Gⱼ with high accuracy. This permits reduction of the area of the substrate 1 occupied by the region 14 of the electrode Eⱼ. It is desirable that the groove Oₙ be formed closely to the marginal edge of the electrode Eₙ on the opposite side from the electrode Eₙ₋₁ so that the region 14 of the electrode Eₙ may occupy less area of the substrate.

Next, a conductive multi-layer 43 (shown for simplicity in Figs. 5F and 5G as but a single layer but in fact comprising the layers which will ultimately form the electrodes F₁ to Fₙ and F_{O} referred to in respect to Figs. 1 and 2) is formed, for example by vapor deposition on the substrate 1 to cover the non-single-crystal semiconductor laminate members Q₁ to Qₙ and to fill the grooves O₁ to Oₙ, forming coupling portions K₁ to Kₙ. In this case, the conductive multi-layer 43 is formed to extend on the substrate 1 except both marginal portions in its lengthwise direction but it covers both marginal portions of the substrate 1 in its widthwise direction.

Next, the conductive multi-layer 43 is selectively removed by laser beam scanning as is the case with the non-single-crystal semiconductor laminate members Q₁ to Qₙ. By this laser beam scanning there are formed in the conductive multi-layer 43 n isolating portions H₁ to Hₙ, n electrodes F₁ to Fₙ isolated by the isolating portions H₁ to Hₙ₋₁, respectively, and opposite to the electrodes E₁ to Eₙ across the non-single-crystal semicondcutor laminate members Q₁ to Qₙ, respectively, and an elctrode F₀ isolated by the isolating portion Hₙ from the electrode Fₙ and opposite to electrode Eₙ. In this case, the laser beam scanning is carried out so that the electrode Fⱼ₊₁ may be linked with the electrode Eⱼ through the coupling portion Kⱼ and so that the electrode F₀ may be linked with the electrode Eₙ through the coupling portion Kₙ.

By the abovesaid laser beam scanning, the isolating portion Hᵢ (i= 1, 2, ...n) can be formed to extend into the non-single-crystal semiconductor laminate member Qᵢ.

As is the case with the conductive layer 41, the laser beam scanning of the conductive layer 43 can be effected in the air and may also be carried out in the atmosphere of a gas which reacts with the materials of the conductive layer 43 and the non-single-crystal semiconductor laminate members Q₁ to Qₙ at high temperatures to spatter them from the substrate surface. The gas used in this case may be hydrogen fluoride, hydrogen chloride or Freon (RTM) gas.

Also in the case of performing the laser beam scanning of the conductive layer 43 in the air, it is desirable that the laser beam scanning be followed by deburring through the use of the aforesaid gas or etching using the aforesaid liquid as the etchant.

By the laser beam scanning for the conductive layer 43, the isolating portion Hᵢ can be provided in the form of a groove as illustrated.

The laser beam scanning of the conductive layer 43 can also be carried out easily and accurately by the aid of a computer while monitoring through the video camera device.

Further, the isolating portion Hᵢ is formed a predetermined distance apart from the groove Oᵢ laterally thereof (on the left thereof in the drawing). The abovesaid predetermined distance is large as compared with the thickness of the non-single-crystal semiconductor laminate member 43, but it may preferably be selected as small as possible. By the aid of a computer the isolating portion Hᵢ can be formed in close proximity to the groove Oᵢ with high precision. This allows reduction of the area of the substrate 1 occupied by the region 13 formed in the non-single-crystal semiconductor laminate member Qᵢ.

Next, a transparent antireflection and protective film 15 is formed by a known method on the substrate to cover the electrodes F₁ to Fₙ and F₀ and the isolating portion H₁ as shown in Figs. 4A and 4B.

In the manner described above, the photoelectric conversion device of the present invention, shown in Figs. 1 and 2, may be manufactured.

The above is a description of an exemplary embodiment of the present invention and an example of its manufacturing method.

According to the photoelectric conversion device of Figs. 1 and 2, when light (not shown) is incident thereon from the side of the substrate 1 or the electrodes F₁ to Fₙ each semiconductor elements Uᵢ (i=1, 2, ...n) carries out photoelectric conversion to generate photovoltage across its electrodes Eᵢ and Fᵢ.

The electrode Fⱼ₊₁ (j= 1, 2, ...(n-1)) of the semiconductor element Uⱼ₊₁ is linked with the electrode Eⱼ of the semiconductor element Uⱼ through the coupling portion Kⱼ and the electrode F₁ of the semiconductor element U₁ is connected to an external connection terminal 11 and the electrode Eₙ of the semiconductor element Uₙ is connected to an external connection terminal 12 through the coupling portion Kₙ and the electrode F₀.

Accordingly, the semiconductor elements U₁ to Uₙ are sequentially connected in series through the coupling portions K₁ to Kₙ₋₁ and connected to the external connection terminals 11 and 12. Consequently, upon incidence of light, there is developed across the external connection terminals 11 and 12 the photovoltage that is equal to the sum of voltage produced by the semiconductor elements U₁ to Uₙ.

In addition, by forming the electrodes Eᵢ or Fᵢ of the semiconductor element Uᵢ as reflective electrodes as described previously incident light can efficiently be utilized by the semiconductor Uᵢ, providing for increased photovoltage per unit area of the substrate 1.

Besides, in the case where the layer of the electrode Fᵢ contacting the non-single-crystal semiconductor laminate member Qᵢ is formed as the aforesaid conductive metal oxide layer, an excellent ohmic contact can be made between the electrode Eᵢ and the non-single-crystal semiconductor laminate member Qᵢ, so that high photovoltage can be obtained from the semiconductor element Uᵢ with practically no loss.

These features can be made more marked if the layer of the electrode Fᵢ contacting the non-single-crystal semiconductor laminate member Qᵢ is formed of a tin oxide or a metallic oxide consisting principally thereof, or an indium oxide or a metallic oxide consisting principally thereof, depending on whether the non-single-crystal semiconductor layer of the non-single-crystal semiconductor laminate member Qᵢ contacting the electrode Fᵢ is P-type or N-type.

Where the groove Oⱼ cut in the non-single-crystal semiconductor laminate member Qⱼ is extended into the electrode Eⱼ as illustrated, the coupling portion Kⱼ extending from the electrode Fⱼ₊₁ makes side-contact with the electrode Eⱼ and hence makes good ohmic contact therewith, ensuring to obtain large electromotive force across the external connection terminals 11 and 12 with no appreciable loss. This is more marked when the coupling portion Kⱼ and the electrode Eⱼ linked with each other through their metal oxide layers.

Since the isolating portion Hⱼ is formed to extend into the non-single-crystal semiconductor laminate member Qⱼ as illustrated, substantially no leakage occurs through the non-single-crystal semiconductor laminate members Qⱼ between the electrode Eⱼ and Fⱼ₊₁, ensuring to obtain large electromotive force across the external connection terminals 11 and 12.

In the embodiment of Figs. 1 and 2, the non-single-crystal semiconductor laminate member Q₁ of the semiconductor element U₁ is formed on the electrode E₁ to extend onto the substrate 1 passing on the side surface of the electrode E₁ on the opposite side from the non-single-crystal semiconductor laminate member Q₂, and the electrode F₁ is formed on the non-single-crystal semiconductor laminate member Q₁ to extend onto the substrate 1 passing on the side surface and the extended portion is used as the external connection terminal 11. With such an arrangement, the series circuit of the semiconductor elements U₁ to Uₙ can easily be connected at one end to the external connection terminal 11. This permits simplification of the construction of photoelectric conversion device as a whole.

Further, in the embodiment of Figs. 1 and 2, the non-single-crystal semiconductor laminate member Qₙ is formed to extend on the side surface of the electrode Eₙ on the opposite side from the electrode Eₙ₋₁ towards the substrate 1. The electrode F₀ is formed on the non-single-crystal semiconductor laminate member Qₙ to extend to the substrate surface and the electrode F₀ is coupled with the electrode Eₙ through the coupling portion Kₙ. And the extended portion of the electrode F₀ on the substrate 1 is used as the external connection terminal 12. Accordingly, the series circuit of the semiconductor elements U₁ to Uₙ cab easily be connected at one end to the external connection terminal 12, permitting simplification of the overall structure of the photoelectric conversion device.

A description will be given of other embodiments of the photoelectric conversion device of the present invention.

In the embodiment of the photoelectric conversion device of the present invention depicted in Figs. 1 to 3, the groove Oⱼ extends across the electrode Eⱼ to reach the substrate 1, and the coupling portion Kⱼ makes contact only with the side of the electrode Eⱼ exposed to the groove Oⱼ.

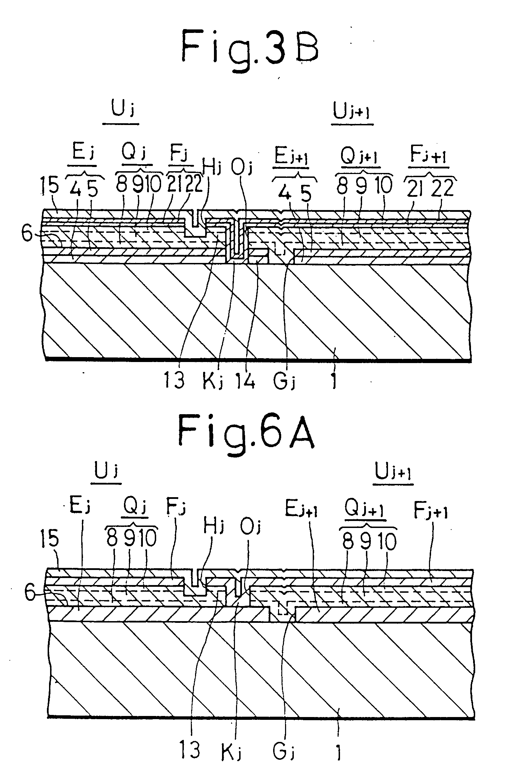

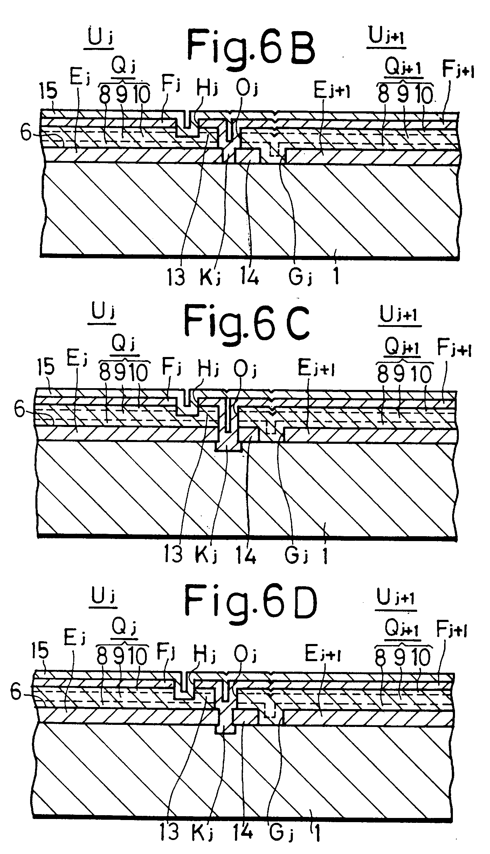

In other embodiments of the photoelectric conversion device of the present invention, however, as shown in Fig. 6A where for simplicity the multi-layer electrode Fⱼ is shown as only one layer, the groove Oⱼ is not extended into the electrode Eⱼ and the coupling portion Kⱼ is formed to make contact only with the top of the electrode Eⱼ exposed to the groove Oⱼ.

Further, as shown in Fig. 6B where again electrode Fⱼ is shown as only one layer, the width of the groove Oⱼ in the electrode Eⱼ is made smaller than in the non-single-crystal semiconductor laminate member Qⱼ and the coupling portion Kⱼ is formed to make contact with the top and side of the electrode Eⱼ exposed to the groove Oⱼ.

Moreover, according to another embodiment, as shown in Fig. 6C where the multi-layer construction of electrode Fⱼ is not shown the groove Oⱼ is extended into the substrate 1 with a greater width than in the electrode Eⱼ, and the coupling portion Kⱼ is formed to make contact with the side and bottom of the electrode Eⱼ exposed to the groove Oⱼ.

According to another embodiment, as shown in Fig. 6D where again the showing of electrode Fⱼ is simplified, the groove Oⱼ is extended across the electrode Eⱼ as in the case of Fig. 6B and into the substrate 1 as in the case of Fig. 6C, and the coupling portion Kⱼ is formed to make contact with the top, side and bottom of the electrode Eⱼ exposed to the groove Oⱼ.

In the embodiments illustrated in Figs. 6A to 6D, the groove Oⱼ can easily be formed by the same laser beam scanning as that for the non-single crystal semi-conductor laminate member Qⱼ described previously in respect of Fig. 5 but, in this case, the intensity of the laser beam is adjusted suitably.

It will be seen that any of the structures of the embodiments provided with the grooves shown in Figs. 6A to 6D possesses the same advantages as are obtainable with the embodiment of Figs. 1 to 3, though not described in detail.

In the embodiment of the photoelectric conversion device shown in Figs. 1 to 3, the electrodes Fⱼ and Fⱼ₊₁ of the semiconductor elements Uⱼ and Uⱼ₊₁ are isolated by the isolating portion provided in the form of a groove and the isolating portion Hⱼ extends into the non-single-crystal semiconductor laminate member Qᵢ. The embodiment of Fig. 7B corresponding to Fig. 3 is identical in construction with the embodiment of Figs. 1 to 3 except that the isolating portion Hⱼ extends across the non-single-crystal semiconductor laminate member Qᵢ. Such isolating portions H₁ to Hₙ can easily be formed by adjusting the scanning speed and/or power of the laser beam in the laser beam scanning for the conductive layer 43 described previously in connection with Fig. 5.

Further, the embodiment of Fig. 7C corresponding to Fig. 3 photoelectric conversion device of the present invention is identical in construction with the embodiment of Figs. 1 to 3 except that the isolating portion Hⱼ consists of the groove 16 defined between the electrodes Fⱼ and Fⱼ₊₁ and the oxide 17 of the non-single-crystal semiconductor forming the non-single-crystal semiconductor laminate member Qⱼ, which is formed in the upper half portion thereof.

Such isolating portions H₁ to Hₙ can easily be formed by carrying out in an oxygen atmosphere the laser beam scanning for the conductive layer 43 described previously with respect to Fig. 5.

Likewise, the embodiment of Fig. 7D is identical in construction with the embodiment of Figs. 1 to 3 except that the isolating portion Hⱼ is formed by an oxide 18 which results from oxidation of the conductive material forming the electrodes Fⱼ and Fⱼ₊₁ and separates them as shown. Such isolating portions H₁ to Hₙ can easily be formed by the same laser beam scanning as that employed for the third embodiment of Fig. 7C.

The embodiment of Fig. 7A is also identical in construction with the embodiment of Figs. 1 to 3 except that the isolating portion Hⱼ is formed by the groove 16 which hardly extends into the non-single-crystal semiconductor laminate member Qⱼ but separates the electrodes Eⱼ and Eⱼ₊₁ as shown. Such isolating portion H₁ to H_{N} can easily be formed by adjusting the scanning speed and/or power of the laser beam in the laser beam scanning as in the embodiment of Fig. 5.

Another embodiment of Fig. 7E is identical in construction with the embodiment of Figs. 1 to 3 except that the isolating portion Hⱼ has such a structure that an oxide layer is formed on the interior surface of the groove described previously with respect to Fig. 3.

Such an isolating portion Hⱼ can easily be formed by perfoming the laser beam scanning for the conductive layer 43 mentioned previously with regard to Fig. 5 in the oxygen atmosphere as in the embodiment of Fig. 7D.

It is evident that all the arrangements of the embodiments having the isolating portions H₁ to Hₙ, shown in Figs. 7A to E, have the same features as those of the embodiment of Figs. 1 to 3, though not described in detail.

In the embodiment of Figs. 1 to 3, the series circuit of the semiconductor elements U₁ to Uₙ constituting one photoelectric conversion device on the substrate 1 is connected at one end to the external connection terminal 11, which is formed by the extended portion of the electrode E₁ of the semiconductor element U₁ on the substrate 1, and connected at the other end to the external connection terminal 12 which is formed by the extended portion of the electrode F₀ on the substrate 1 and connected to the electrode Eₙ through the coupling portion Kₙ.

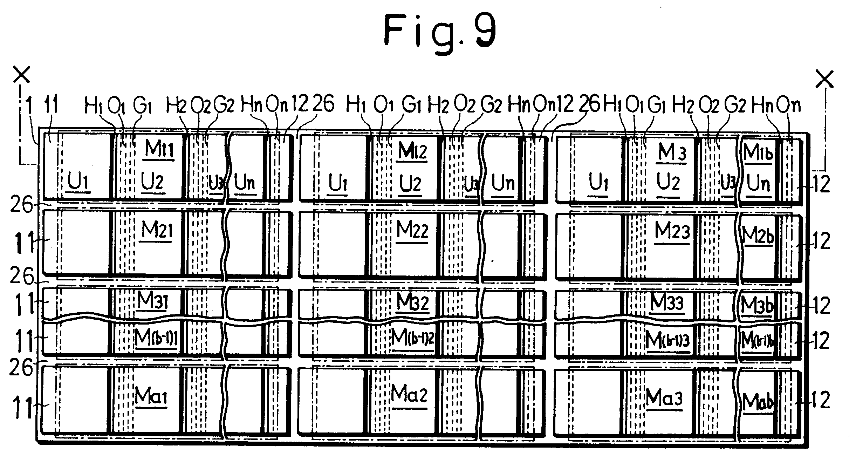

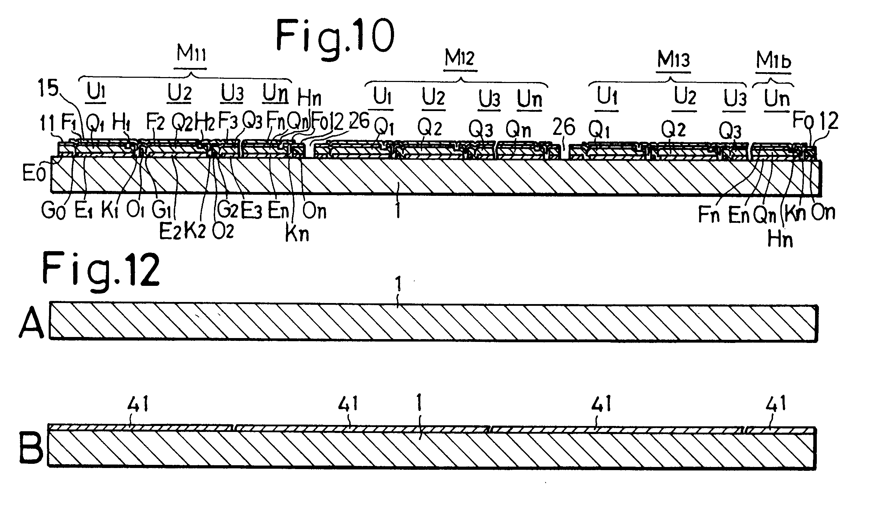

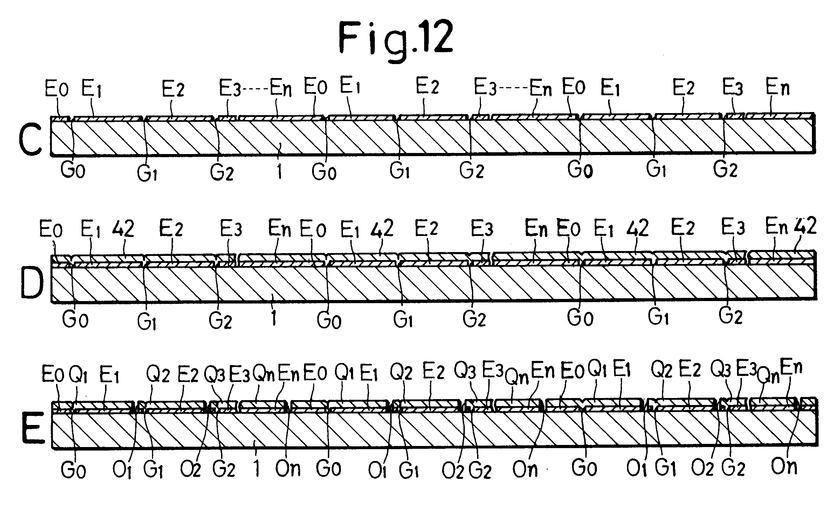

In another embodiment of the present invention, however, a plurality a x b of such photoelectric conversion devices, each made up of the n semiconductor elements U₁ to Uₙ connected in series as shown in Figs. 1 and 2, are arranged in the form of a matrix consisting of a rows and b columns as illustrated in Figs. 9 and 10 corresponding to Figs. 1 and 2. In Figs. 9 and 10 reference character Mᵣₛ (r=1, 2,... a and s=1, 2,...b) indicates each photoelectric conversion device disposed at one of the intersections of rows and columns. The photoelectric conversion devices M₁₁ to M_{1b}, M₂₁ to M_{2b}, ... and Mₐ₁ to M_{ab} are isolated by grooves 26 from adjacent ones of them.

In the embodiment illustrated in Figs. 9 and 10, the photoelectric conversion device Mᵣₛ is identical in construction with the photoelectric conversion device of the embodiment of Figs. 1 to 3 except in the following points:
As shown in Fig. 11A, an electrode E₀ similar to the electrodes E₁ to Eₙ is formed on the substrate 1 on the side of the electrode E₁ of the semiconductor element U₁ on the opposite side from the electrode E₁ and the electrode E₀ is isolated by a groove G₀ similar to those G₁ to Gₙ₋₁.

Further, the non-single-crystal semiconductor laminate member Q₁ of the semiconductor element U₁ does not extend from the electrode E₁ to the substrate surface but instead it extends across the groove G₀ to the marginal edge of the electrode E₀.

The electrode F₁ of the semiconductor element U₁, which is formed to cover the non-single-crystal semiconductor laminate member Q₁ and extend to the substrate 1 in the first embodiment, is formed to extend to the marginal edge of the non-single-crystal semiconductor laminate member Q₁ correspondingly. And the external connection terminal 11 is formed by the end portion of the electrode F₁ on the non-single-crystal semiconductor laminate member Q₁ on the opposite side from the electrode F₂.

Moreover, as shown in Fig.11B, the non-single-crystal semiconductor laminate member Qₙ of the semiconductor element Uₙ is formed to extend to the marginal edge of the electrode Eₙ.

The electrode F₀, though formed to cover the non-single-crystal semiconductor laminate member Qₙ and to extend to the substrate 1 in the embodiment of Figs. 1 to 3, extends to the marginal edge of the non-single-crystal semiconductor laminate member Qₙ correspondingly. And the external connection terminal 12 is formed by the end portion of the electrode F₀ on the non-single-crystal semiconductor laminate member Qₙ on the opposite side from the electrode Fₙ.

The above is a description of the abovesaid another embodiment of the photoelectric conversion device of the present invention.

The photoelectric conversion device of such a construction can be obtained by a manufacturing method similar to that employed for the fabrication of the photoelectric conversion device of the embodiment of Figs. 1 to 3.

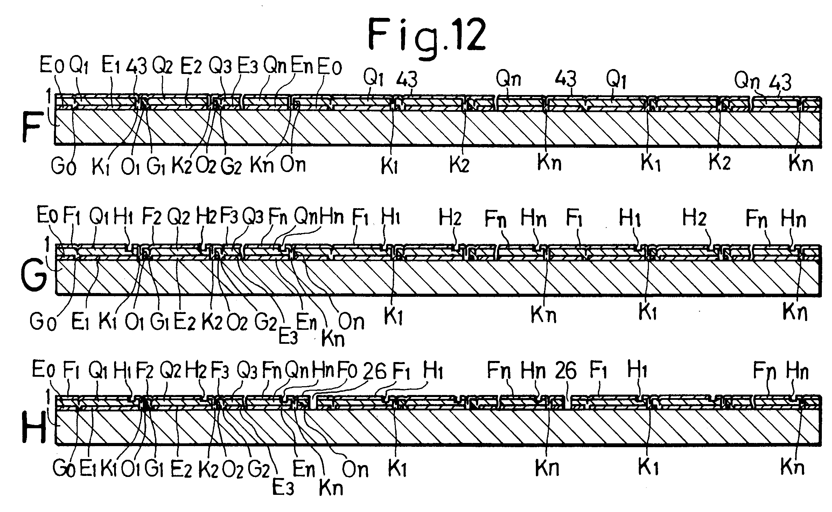

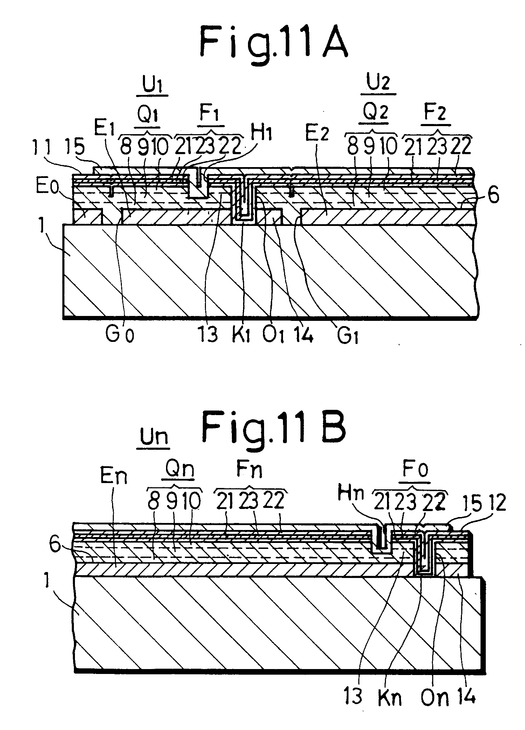

That is, as shown in Figs. 12A to G corresponding to Figs. 5A to G, a x b photoelectric conversion devices M₁₁ to M_{1b}, M21 to M_{2b}, ... and Mₐ₁ to M_{ab} are formed on the substrate 1 by a sequence of steps similar to those shown in Figs. 5A to G, though not described in detail. Next, as shown in Fig. 12H, the grooves 26 are formed by the same laser beam scanning as described previously in respect of Fig. 4.

Next, the light transparent antireflection and protective film 15 (not shown) is formed.

In this way, the structure of the embodiment referred to previously in conjunction with Figs. 9 and 10 is obtained.

The above is a description of the abovesaid another embodiment and its manufacturing method.

The photoelectric conversion device of Figs.9 10 is identical in construction with the embodiment of Figs. 1 to 3 except in the abovesaid points, and hence presents the same advantages as those obtainable with the embodiment of Figs. 1 to 4, though not described in detail.

Moreover, according to the embodiment of Figs. 9 and 10, the photoelectric conversion devices M₁₁ to M_{1b}, M₂₁ to M_{2b}, ...and Mₐ₁ to M_{ab} are formed on the substrate 1 and separated by the grooves 26. If the substrate 1 is formed by a flexible, insulating sheet-like member, it can easily be severed at the positions of the grooves 26 into a x b independent photoelectric conversion devices.

Incidentally, the embodiment of Figs. 9 and 10 can also be modified and varied in the same manner as in the second to ninth embodiments of Figs. 6 to 8 which are modifications and variations of the embodiment of Figs. 1 to 4.

While in the foregoing embodiments of the present invention the groove Oⱼ formed in the non-single-crystal semiconductor laminate members Qⱼ is shown to be a groove which continuously extends in the vertical direction to completely isolate the non-single-crystal semiconductor laminate memers Qⱼ and Qⱼ₊₁ mechanically, the groove Oⱼ may also be foremd to discontinuously extend in the vertical direction so that the non-single-crystal semiconductor laminate members Qⱼ and Qⱼ₊₁ may not completely be isolated by the groove Oⱼ from each other.

## Claims

1. A photoelectric conversion device comprising:
a substrate having an insulating surface; and
a plurality of semiconductor elements U₁ to Uₙ, n being an integer larger than one, formed thereon in side by side relationship and connected sequentially in series with one another;
the semiconductor element Uᵢ, i=1, 2,...n, comprising a first electrode Eᵢ formed on the substrate, a silicon based non-single-crystal semiconductor laminate member Qᵢ formed on the first electrode Eᵢ and having formed therein at least one PN or PIN junction, and a second electrode Fᵢ formed on the non-single-crystal semiconductor laminate member Qᵢ in opposing relationship to the first electrode Eᵢ; the first electrode E₁ to Eₙ being separated from one another by first grooves G₁ to Gₙ₋₁;
the second electrodes F₁ to Fₙ being separated from one another by isolating portions H₁ to Hₙ₋₁; and
the second electrode Fⱼ₊₁, j=1,2... (n-1), of the semiconductor element Uⱼ₊₁ being coupled with the first electrode Eⱼ of the semiconductor element Uⱼ through a coupling portion Kⱼ consisting of an integrally formed extension of the second electrode Fⱼ₊₁, said coupling portion Kⱼ being located at a position where a portion of the second electrode Fⱼ₊₁ extends on the non-single-crystal semiconductor laminated member Qⱼ opposite to a portion of the first electrode Eⱼ and passing through a second groove Oⱼ provided between at least portions of the non-single-crystal semiconductor laminate members Qⱼ and Qⱼ₊₁ to separate said members and to expose the first electrode Eⱼ;
characterized in that:
the second electrode Fᵢ and the coupling portion Kⱼ consists of a multi-layered member including a conductive metal oxide layer (21) making contact with the non-single-crystal semiconductor laminate member Qᵢ and a further conductive material layer (22) formed on the said metal oxide layer.

2. A photoelectric conversion device according to claim 1, wherein the further conductive material layer (22) of the second electrode Fᵢ comprises a sublimable metal layer.

3. A photoelectric conversion device according to claim 2, wherein the sublimable metal layer (22) is a layer formed of chromium or consisting principally thereof.

4. A photoelectric conversion device according to claim 1 or 2 or 3, wherein the isolating portion Hⱼ between the second electrodes Fⱼ and Fⱼ₊₁ consists of a groove containing insulating material.

5. A photoelectric conversion device according to claim 4, wherein a local insulating layer is formed on the non-single-crystal semiconductor laminate member Qⱼ in the region thereof corresponding to the position of isolating portion Hⱼ.

6. A photoelectric conversion device according to claim 4, wherein a continuous insulating layer is provided on the second electrodes Fⱼ and Fⱼ₊₁ and extends into the isolating portion Hⱼ.

7. A photoelectric conversion device according to claim 1, wherein the conductive material layer (22) of the second electrode Fᵢ comprises a reflective metal layer.

8. A photoelectric conversion device according to claim 7, wherein the reflective metal layer (22) is a layer formed of silver or aluminium or consisting principally thereof.

9. A photoelectric conversion device according to claim 7, wherein the isolating portion Hⱼ between the second electrodes Fⱼ and Fⱼ₊₁ consists of, a groove which extends into the non-single-crystal semiconductor laminate member Qⱼ.

10. A photoelectric conversion device according to claim 9, wherein an insulating layer is formed on the region of the surface of the non-single-crystal semiconductor laminate member Qⱼ which is exposed to the said groove.

11. A photoelectric conversion device according to claim 1, wherein the non-single-crystal semiconductor laminate member Qᵢ comprises an N-type non-single-crystal semiconductor layer in contact with the second electrode Fᵢ and wherein the said conductive metal oxide layer (21) of the second electrode Fᵢ is a layer formed of indium oxide or consisting of principally thereof.

12. A photoelectric conversion device according to claim 1, wherein the non-single-crystal semiconductor laminate member Qᵢ comprises a P-type non-single-crystal semiconductor layer making contact with the second electrode Fᵢ, and wherein the said metal oxide layer (21) of the second electrode Fᵢ is a layer formed of tin oxide or consisting principally thereof.

13. A photoelectric conversion device according to claim 11 or 12, wherein the further conductive material layer (22) of the second electrode Fᵢ comprises a sublimable metal layer.

14. A photoelectric conversion device according to claim 13, wherein the sublimable metal layer (22) is a layer formed of chromium or consisting principally thereof.

15. A photoelectric conversion device according to claim 1, wherein the first electrode Eᵢ is formed as a multi-layered member comprising a conductive material layer (4) and a conductive metal oxide layer (5) formed on the said conductive material layer and making contact with the non-single-crystal semiconductor laminate member Qᵢ, and wherein the metal oxide layer (21) of the coupling portion Kⱼ is coupled with the metal oxide layer (5) of the first electrode Eⱼ.

16. A method of making a photoelectric conversion device, comprising the steps of:
forming a first electrically conductive electrode layer on a substrate having an insulating surface;
selectively removing said first electrode layer by laser beam scanning, to form therein (n-1), wherein n is an integer larger than 2, sequentially arranged first grooves G₁ to Gₙ₋₁ defining n sequentially arranged first electrodes E₁ to Eₙ separated by the first grooves G₁ to Gₙ₋₁, respectively;
forming a continuous silicon based non-single-crystal semiconductor laminate layer having at least one PN or PIN junction over the first grooves G₁ to Gₙ₋₁ and the electrodes E₁ to Eₙ;
selectively removing said non-single-crystal semiconductor laminate layer by laser beam scanning to form therein n-1 sequentially arranged second grooves 0₁ to 0ₙ₋₁ extending therethrough to expose the first electrodes E₁ to Eₙ₋₁ and define n semiconductor laminate members Q₁ to Qₙ each associated with a respective one of the electrodes E₁ to Eₙ;
forming a second electrically conductive electrode layer which extends continuously over the non-single-crystal semiconductor laminate members Q₁ to Qₙ and into the grooves 0₁ to 0ₙ₋₁ to define coupling portions K₁ to Kₙ₋₁ which are connected to the first electrodes E₁ to Eₙ₋₁ through the grooves 0₁ to 0ₙ₋₁; and
selectively removing said second electrode layer by laser beam scanning to form therein isolating portions H₁ to Hₙ₋₁ located on the non-single-crystal semiconductor laminate members Q₁ to Qₙ₋₁ and define n sequentially arranged second electrodes F₁ to Fₙ generally opposite to the first electrodes E₁ to Eₙ through the non-single-crystal semiconductor laminate members Q₁ to Qₙ, respectively, the second electrodes F₂ to Fₙ being connected to the first electrodes E₁ to Eₙ₋₁ through the coupling portions K₁ to Kₙ₋₁, respectively:
characterized in that:
said second electrode layer is formed as a multi-layer comprising a conductive metal oxide layer (21) in contact with said semiconductor laminate members Q₁ to Qₙ and a further conductive layer (22) overlying said metal oxide layer, said further conductive layer consisting of a sublimable metal.

17. A method of making a photoelectric conversion device according to claim 16, wherein the second groove 0ⱼ, j=1,2...(n-1), is formed to extend into the thickness of the first electrode Eⱼ so that the coupling portion Kⱼ is connected with the first electrode Eⱼ at the sides of the groove 0ⱼ.

18. A method of making a photoelectric conversion device according to claim 16 or 17, wherein the isolating portions H₁ to Hₙ₋₁ are formed as grooves which extend through the second electrode layer and into the non-single-crystal semiconductor laminate members Q₁ to Qₙ₋₁.

19. A method of making a photoelectric conversion device according to claim 16 or 17 or 18, wherein one or more of the laser beam scanning steps is carried out in the air.

20. A method of making a photoelectric conversion device according to claim 19, wherein one or more of the laser beam scanning steps is followed by an etching treatment using a gas, such as hydrogen fluoride (HF), hydrogen chloride (HCl) or a fluorocarbon gas (CF₄, CHF₃, CClF₂ or the like), or a liquid, such as hydrofluoric acid (HF), hydrochloric acid (HCl) or a fluorocarbon liquid (C₂F₃Cl₄ or the like).

21. A method of making a photoelectric conversion device according to claim 16 or 17 or 18, wherein the laser beam scanning of the second electrode layer is performed in an atmosphere of oxygen.

## Patentansprüche

1. Photovoltaischer Wandler mit:
- einem Substrat mit einer isolierenden Oberfläche; und
- mehreren Halbleiterelementen U₁ bis Uₙ, wobei n eine ganze Zahl größer als Eins ist, die darauf Seite-an-Seite ausgebildet sind und sequentiell miteinander in Reihe geschaltet sind;
- wobei das Halbleiterelement Uᵢ, i = 1, 2, ..., n eine erste, auf dem Substrat ausgebildete Elektrode Eᵢ, ein auf der ersten Elektrode Eᵢ ausgebildetes nichteinkristallines Halbleiterlaminatteil Qᵢ auf Siliziumgrundlage, in dem mindestens ein pn- oder pin-Übergang ausgebildet ist, und eine auf dem nichteinkristallinen Halbleiterlaminatteil Qᵢ ausgebildete, der ersten Elektrode Eᵢ gegenüberliegende zweite Elektrode Fᵢ aufweist; wobei die ersten Elektroden E₁ bis Eₙ voneinander durch erste Gräben G₁ bis Gₙ₋₁ getrennt sind;
- wobei die zweiten Elektroden F₁ bis Fₙ voneinander durch Isolierbereiche H₁ bis Hₙ₋₁ getrennt sind; und
- wobei die zweite Elektrode Fⱼ₊₁, j = 1, 2, ... (n-1) des Halbleiterelements Uⱼ₊₁ mit der ersten Elektrode Eⱼ des Halbleiterelements Uⱼ über einen Kopplungsbereich Kⱼ verbunden ist, der aus einer integral ausgebildeten Verlängerung der zweiten Elektrode Fⱼ₊₁ besteht, wobei der Kopplungsbereich Kⱼ an einer Stelle angeordnet ist, an der sich ein Bereich der zweiten Elektrode Fⱼ₊₁ auf dem nichteinkristallinen Halbleiterlaminatteil Qⱼ einem Bereich der ersten Elektrode Eⱼ gegenüberliegend erstreckt und durch einen zweiten Graben Oⱼ geht, der mindestens zwischen Bereichen der nichteinkristallinen Halbleiterlaminatteile Qⱼ und Qⱼ₊₁ ausgebildet ist, um diese Teile voneinander zu trennen und die erste Elektrode Eⱼ freizulegen;
dadurch gekennzeichnet, daß:
- die zweite Elektrode Fᵢ und der Kopplungsbereich Kⱼ aus einem mehrschichtigen Teil bestehen, das eine leitende Metalloxidschicht (21), die den Kontakt zum nichteinkristallinen Halbleiterlaminatteil Qᵢ herstellt, und eine weitere leitende Materialschicht (22) beinhaltet, die auf der Metalloxidschicht ausgebildet ist.

2. Photovoltaischer Wandler nach Anspruch 1, bei dem die weitere leitende Materialschicht (22) der zweiten Elektrode F₁ eine sublimierbare Metallschicht aufweist.

3. Photovoltaischer Wandler nach Anspruch 2, bei dem die sublimierbare Metallschicht (22) eine aus Chrom gebildete Schicht ist oder im wesentlichen daraus besteht.

4. Photovoltaischer Wandler nach einem der Ansprüche 1 oder 2 oder 3, bei dem der Isolierbereich Hⱼ zwischen den zweiten Elektroden Fⱼ und Fⱼ₊₁ aus einem isolierendes Material enthaltenden Graben besteht.

5. Photovoltaischer Wandler nach Anspruch 4, bei dem eine örtlich isolierende Schicht auf dem nichteinkristallinen Halbleiterlaminatteil Qⱼ in demjenigen Teil desselben ausgebildet ist, der der Position des Isolierbereichs Hⱼ entspricht.

6. Photovoltaischer Wandler nach Anspruch 4, bei dem eine kontinuierliche, isolierende Schicht auf den zweiten Elektroden Fⱼ und Fⱼ₊₁ ausgebildet ist, die sich in den Isolierbereich Hⱼ hinein erstreckt.

7. Photovoltaischer Wandler nach Anspruch 1, bei dem die leitende Materialschicht (22) der zweiten Elektrode Fⱼ eine reflektierende Metallschicht aufweist.

8. Photovoltaischer Wandler nach Anspruch 7, bei dem die reflektierende Metallschicht (22) eine aus Silber oder Aluminium gebildete Schicht ist oder sie im wesentlichen hieraus besteht.

9. Photovoltaischer Wandler nach Anspruch 7, bei dem der Isolierbereich Hⱼ zwischen den zweiten Elektroden Fⱼ und Fⱼ₊₁ aus einem Graben besteht, der sich in das nichteinkristalline Halbleiterlaminatteil Qⱼ hinein erstreckt.

10. Photovoltaischer Wandler nach Anspruch 9, bei dem eine isolierende Schicht auf demjenigen Bereich der Oberfläche des nichteinkristallinen Halbleiterlaminatteils Qⱼ ausgebildet ist, der zum Graben hin frei liegt.

11. Photovoltaischer Wandler nach Anspruch 1, bei dem das nichteinkristalline Halbleiterlaminatteil Qᵢ eine nichteinkristalline Halbleiterschicht vom n-Typ in Kontakt mit der zweiten Elektrode Fᵢ aufweist und bei dem die leitende Metalloxidschicht (21) der zweiten Elektrode Fᵢ eine aus Indiumoxid gebildete Schicht ist oder im wesentlichen hieraus besteht.

12. Photovoltaischer Wandler nach Anspruch 1, bei dem das nichteinkristalline Halbleiterlaminatteil Qᵢ eine nichteinkristalline Halbleiterschicht vom p-Typ aufweist, die die zweite Elektrode Fᵢ kontaktiert, und bei dem die Metalloxidschicht (21) der zweiten Elektrode Fᵢ eine aus Zinnoxid gebildete Schicht ist oder im wesentlichen hieraus besteht.

13. Photovoltaischer Wandler nach einem der Ansprüche 11 oder 12, bei dem die weitere, leitende Materialschicht (22) der zweiten Elektrode Fᵢ eine sublimierbare Metallschicht aufweist.

14. Photovoltaischer Wandler nach Anspruch 13, bei dem die sublimierbare Metallschicht (22) eine aus Chrom gebildete Schicht ist oder im wesentlichen hieraus besteht.

15. Photovoltaischer Wandler nach Anspruch 1, bei dem die erste Elektrode Eᵢ als Mehrschichtteil ausgebildet ist, das eine leitende Materialschicht (4) und eine leitende Metalloxidschicht (5) aufweist, die auf der leitenden Metallschicht ausgebildet ist und den Kontakt zum nichteinkristallinen Halbleiterlaminatteil Qᵢ herstellt, und bei dem die Metalloxidschicht (21) des Kopplungsbereichs Kⱼ mit der Metalloxidschicht (5) der ersten Elektrode Eⱼ verbunden ist.

16. Verfahren zum Herstellen eines photovoltaischen Wandlers, mit den folgenden Schritten:
- Ausbilden einer ersten elektrisch leitenden Elektrodenschicht auf einem Substrat mit einer isolierenden Oberfläche;
- selektives Entfernen der ersten Elektrodenschicht durch Laserstrahlabrastern, um in ihr (n-1), wobei n eine ganze Zahl größer als 2 ist, sequentiell angeordnete erste Gräben G₁ bis Gₙ₋₁ auszubilden, die n sequentiell angeordnete erste Elektroden E₁ bis Eₙ festlegen, die jeweils durch die ersten Gräben G₁ bis Gₙ₋₁ voneinander getrennt werden;
- Ausbilden einer zusammenhängenden nichteinkristallinen Halbleiterlaminatschicht auf Siliziumgrundlage, die mindestens einen pn- oder pin-Übergang aufweist, über den ersten Gräben G₁ bis Gₙ₋₁ und den Elektroden E₁ bis Eₙ;
- selektives Entfernen der nichteinkristallinen Halbleiterlaminatschicht durch Laserstrahlabrastern, um in ihr n-1 sequentiell angeordnete zweite Gräben O₁ bis Oₙ₋₁ auszubilden, die sich durch sie hindurch erstrecken, um die ersten Elektroden E₁ bis Eₙ₋₁ freizulegen und n Halbleiterlaminatteile Q₁ bis Qₙ festzulegen, denen jeweils eine der Elektroden E₁ bis Eₙ zugeordnet ist;
- Ausbilden einer zweiten elektrisch leitenden Elektrodenschicht, die sich kontinuierlich über die nichteinkristallinen Halbleiterlaminatteile Q₁ bis Qₙ und in die Gräben O₁ bis Oₙ₋₁ erstreckt, um Kopplungsbereiche K₁ bis Kₙ₋₁ festzulegen, die mit den ersten Elektroden E₁ bis Eₙ₋₁ über die Gräben O₁ bis Oₙ₋₁ verbunden sind; und
- selektives Entfernen der zweiten Elektrodenschicht durch Laserstrahlabrastern, um in ihr Isolierbereiche H₁ bis Hₙ₋₁ auszubilden, die auf den nichteinkristallinen Halbleiterlaminatteilen Q₁ bis Qₙ₋₁ angeordnet sind und n sequentiell angeordnete zweite Elektroden F₁ bis Fₙ festlegen, die im wesentlichen den ersten Elektroden E₁ bis Eₙ jeweils über die nichteinkristallinen Halbleiterlaminatteile Q₁ bis Qₙ gegenüber liegen, wobei die zweiten Elektroden F₂ bis Fₙ jeweils über die Kopplungsbereiche K₁ bis Kₙ₋₁ mit den ersten Elektroden E₁ bis Eₙ₋₁ verbunden sind:
dadurch gekennzeichnet, daß:
- die zweite Elektrodenschicht als Mehrfachschicht ausgebildet ist, die eine in Kontakt mit den Halbleiterlaminatteilen Q₁ bis Qₙ stehende leitende Metalloxidschicht (21) und eine weitere leitende Schicht (22) aufweist, die über der Metalloxidschicht liegt, wobei die weitere leitenden Schicht aus einem sublimierbaren Metall besteht.

17. Verfahren zum Herstellen eines photovoltaischen Wandlers nach Anspruch 16, bei dem der zweite Graben Oⱼ, j = 1, 2, ... (n-1), so ausgebildet ist, daß er sich in die Dicke der ersten Elektrode Eⱼ in solcher Weise erstreckt, daß der Kopplungsbereich Kⱼ an den Seiten des Grabens Oⱼ mit der ersten Elektrode Eⱼ verbunden ist.

18. Verfahren zum Herstellen eines photovoltaischen Wandlers gemäß den Ansprüchen 16 oder 17, bei dem die Isolierbereiche H₁ bis Hₙ₋₁ als Gräben ausgebildet sind, die sich durch die zweite Elektrodenschicht und in die nichteinkristallinen Halbleiterlaminatteile Q₁ bis Qₙ₋₁ erstrecken.

19. Verfahren zum Herstellen eines photovoltaischen Wandlers nach einem der Ansprüche 16, 17 oder 18, bei dem einer oder mehrere der Laserstrahlabrasterschritte an Luft ausgeführt wird.

20. Verfahren zum Herstellen eines photovoltaischen Wandlers nach Anspruch 19, bei dem einem oder mehreren der Laserstrahlabrasterschritte eine Ätzbehandlung unter Verwendung eines Gases, wie Fluorwasserstoff (HF), Chlorwasserstoff (HCl) oder eines Fluorkohlenwasserstoffgases (CF₄, CHF₃, CClF₂ oder dergleichen), oder einer Flüssigkeit, wie Flußsäure (HF), Salzsäure (HCl) oder eine Fluorkohlenwasserstoffflüssigkeit (C₂F₃Cl₄ oder dergleichen), folgt.

21. Verfahren zum Herstellen eines photovoltaischen Wandlers nach einem der Ansprüche 16, 17 oder 18, bei dem das Laserstrahlabrastern der zweiten Elektrodenschicht in einer Sauerstoffatmosphäre ausgeführt wird.

## Revendications

1. Dispositif de conversion photo-électrique, comprenant:
un substrat comportant une surface isolante; et
une multiplicité d'éléments semi-conducteurs U₁ à Uₙ, n étant un nombre entier supérieur à un, formés côte à côte sur le substrat et reliés en série les uns aux autres de façon séquentielle;
l'élément semi-conducteur Uᵢ, i étant égal à 1, 2, ...n, comprenant une première électrode Eᵢ formée sur le substrat, un élément laminé semi-conducteur, non monocristallin, à base de silicium, Qᵢ, formé sur la première électrode Eᵢ et dans lequel est formée au moins une jonction PN ou une jonction PIN, et une seconde électrode Fᵢ formée sur l'élément laminé semi-conducteur non monocristallin Qᵢ, en regard de la première électrode Eᵢ; les premières électrodes E₁ à Eₙ étant séparées les unes des autres par des premières rainures G₁ à Gₙ₋₁;
les secondes électrodes F₁ à Fₙ étant séparées les unes des autres par des parties isolantes H₁ à Hₙ₋₁; et
la seconde électrode Fⱼ₊₁, j étant égal à 1, 2... (n-1), de l'élément semi-conducteur Uⱼ₊₁ étant reliée à la première électrode Eⱼ de l'élément semi-conducteur Uⱼ par l'intermédiaire d'une partie de couplage Kⱼ qui est un prolongement de la seconde électrode Fⱼ₊₁ formé de façon solidaire avec cette dernière, ladite partie de couplage Kⱼ étant située en un emplacement au niveau duquel une partie de la seconde électrode Fⱼ₊₁ s'étend sur l'élément laminé semi-conducteur non monocristallin Qⱼ, en regard d'une partie de la première électrode Eⱼ, et passant à travers une seconde rainure Oⱼ prévue entre au moins des parties des éléments laminés semi-conducteurs non monocristallins Qⱼ et Qⱼ₊₁ pour séparer lesdits éléments et exposer la première électrode Eⱼ;
caractérisé en ce que:
la seconde électrode Fᵢ et la partie de couplage Kⱼ se composent d'un élément multicouches comportant une couche conductrice en oxyde de métal (21) établissant un contact avec l'élément laminé semi-conducteur non monoscristallin Qᵢ et une autre couche en matière conductrice (22) formée sur ladite couche d'oxyde de métal.

2. Dispositif de conversion photo-électrique selon la revendication 1, dans lequel l'autre couche en matière conductrice (22) de la seconde électrode Fᵢ comprend une couche en métal sublimable.

3. Dispositif de conversion photo-électrique selon la revendication 2, dans lequel la couche en métal sublimable (22) est une couche formée de chrome ou composée en majeure partie de chrome.

4. Dispositif de conversion photo-électrique selon l'une des revendications 1, 2 et 3, dans lequel la partie isolante Hⱼ située entre les secondes électrodes Fⱼ et Fⱼ₊₁ consiste en une rainure contenant une matière isolante.

5. Dispositif de conversion photo-électrique selon la revendication 4, dans lequel une couche isolante locale est formée sur l'élément laminé semi-conducteur non monocristallin Qⱼ dans la région de cet élément correspondant à l'emplacement de la partie isolante Hⱼ.

6. Dispositif de conversion photo-électrique selon la revendication 4, dans lequel une couche isolante continue est prévue sur les secondes électrodes Fⱼ et Fⱼ₊₁ et s'étend jusqu'à l'intérieur de la partie isolante Hⱼ.

7. Dispositif de conversion photo-électrique selon la revendication 1, dans lequel la couche en matière conductrice (22) de la seconde électrode Fᵢ comprend une couche en métal réfléchissant.

8. Dispositif de conversion photo-électrique selon la revendication 7, dans lequel la couche de métal réfléchissant (22) est une couche formée d'argent ou d'aluminium ou se composant en majeure partie d'argent ou d'aluminium.

9. Dispositif de conversion photo-électrique selon la revendication 7, dans lequel la partie isolante Hⱼ située entre les secondes électrodes Fⱼ et Fⱼ₊₁ consiste en une rainure qui s'étend jusqu'à l'intérieur de l'élément laminé semi-conducteur non monocristallin Qⱼ.

10. Dispositif de conversion photo-électrique selon la revendication 9, dans lequel une couche isolante est formée sur la région de la surface de l'élément laminé semi-conducteur non monocristallin Qⱼ qui est exposée à ladite rainure.

11. Dispositif de conversion photo-électrique selon la revendication 1, dans lequel l'élément laminé semi-conducteur non monocristallin Qᵢ comprend une couche semi-conductrice non monocristalline de type N en contact avec la seconde électrode Fᵢ et dans lequel ladite couche conductrice en oxyde de métal (21) de la seconde électrode Fᵢ est une couche formée d'oxyde d'indium ou composée principalement d'oxyde d'indium.

12. Dispositif de conversion photo-électrique selon la revendication 1, dans lequel l'élément laminé semi-conducteur non monocristallin Qᵢ comprend une couche semi-conductrice non monocristalline de type P établissant un contact avec la seconde électrode Fᵢ, et dans lequel ladite couche en oxyde de métal (21) de la seconde électrode Fᵢ est une couche formée d'oxyde d'étain ou composée en majeure partie d'oxyde d'étain.

13. Dispositif de conversion photo-électrique selon la revendication 11 ou la revendication 12, dans lequel l'autre couche de matière conductrice (22) de la seconde électrode Fᵢ est une couche de métal sublimable.

14. Dispositif de conversion photo-électrique selon la revendication 13, dans lequel la couche en métal sublimable (22) est une couche formée de chrome ou composée en majeure partie de chrome.

15. Dispositif de conversion photo-électrique selon la revendication 1, dans lequel la première électrode Eᵢ est réalisée sous la forme d'un élément multicouches comprenant une couche de matière conductrice (4) et une couche d'oxyde de métal conducteur (5) formée sur ladite couche de matière conductrice et établissant un contact avec l'élément laminé semi-conducteur non monocristallin Qᵢ, et dans lequel la couche d'oxyde de métal (21) de la partie de couplage Kⱼ est reliée à la couche d'oxyde de métal (5) de la première électrode Eⱼ.

16. Procédé de fabrication d'un dispositif de conversion photo-électrique, comprenant les étapes consistant à:
former une première couche formant électrode conductrice de l'électricité sur un substrat comportant une surface isolante;
éliminer, de façon sélective, ladite première couche formant électrode par balayage au faisceau laser, pour y former (n-1), n étant un nombre entier supérieur à 2, premières rainures disposées de façon séquentielle, G₁ à Gₙ₋₁, définissant n premières électrodes disposées de façon séquentielle, E₁ à Eₙ, séparées par les premières rainures G₁ à Gₙ₋₁, respectivement;
former une couche laminée continue à base de silicium, semi-conductrice et non monocristalline, comportant au moins une jonction PN ou PIN sur les premières rainures G₁ à Gₙ₋₁ et sur les électrodes E₁ à Eₙ;
éliminer, de façon sélective, ladite couche laminée semi-conductrice non monocristalline par balayage au faisceau laser afin d'y former n-1 secondes rainures disposées de façon séquentielle, 0₁ à Oₙ₋₁ qui la traversent pour exposer les premières électrodes E₁ à Eₙ₋₁ et pour définir n éléments laminés semi-conducteurs Q₁ à Qₙ associés chacun à une électrode respective parmi les électrodes E₁ à Eₙ;
former une seconde couche formant électrode conductrice de l'électricité qui s'étend de façon continue sur les éléments laminés semi-conducteurs non monocristallins Q₁ à Qₙ et à l'intérieur des rainures O₁ à Oₙ₋₁ pour définir des parties de couplage K₁ à Kₙ₋₁ qui sont reliées aux premières électrodes E₁ à Eₙ₋₁ par l'intermédiaire des rainures O₁ à Oₙ₋₁; et
éliminer, de façon sélective, ladite seconde couche formant électrode par balayage au faisceau laser pour y former des parties isolantes H₁ à Hₙ₋₁ situées sur les éléments laminés semi-conducteurs non monocristallins Q₁ à Qₙ₋₁
et définir n secondes électrodes disposées de façon séquentielle, F₁ à Fₙ, généralement en regard des premières électrodes E₁ à Eₙ par l'intermédiaire des éléments laminés semi-conducteurs non monocristallins Q₁ à Qₙ, respectivement, les secondes électrodes F₂ à Fₙ étant reliées aux premières électrodes E₁ à Eₙ₋₁ par l'intermédiaire des parties de couplage K₁ à Kₙ₋₁, respectivement;
caractérisé en ce que:
ladite seconde couche formant électrode est réalisée sous la forme de couches multiples comprenant une couche d'oxyde de métal conductrice (21) en contact avec lesdits éléments laminés semi-conducteurs Q₁ à Qₙ, et une autre couche conductrice (22) superposée à ladite couche d'oxyde de métal, ladite autre couche conductrice se composant d'un métal sublimable.

17. Procédé de fabrication d'un dispositif de conversion photo-électrique selon la revendication 16, dans lequel la seconde rainure Oⱼ, j étant égal à 1, 2, ...(n-1), est formée de façon à s'étendre dans l'épaisseur de la première électrode Eⱼ de sorte que la partie de couplage Kⱼ est reliée à la première électrode Eⱼ au niveau des côtés de la rainure Oⱼ.

18. Procédé de fabrication d'un dispositif de conversion photo-électrique selon la revendication 16 ou la revendication 17, dans lequel les parties isolantes H₁ à Hₙ₋₁ sont réalisées sous la forme de rainures qui s'étendent à travers la seconde couche formant électrode et à l'intérieur des éléments laminés semi-conducteurs non monocristallins Q₁ à Qₙ₋₁.

19. Procédé de fabrication d'un dispositif de conversion photo-électrique selon l'une des revendication 16, 17 et 18, dans lequel l'une ou plusieurs des étapes de balayage au faisceau laser sont effectuées dans l'air.

20. Procédé de fabrication d'un dispositif de conversion photo-électrique selon la revendication 19, dans lequel l'une ou plusieurs des étapes de balayage au faisceau laser sont suivies d'un traitement d'attaque utilisant un gaz, tel que le fluorure d'hydrogène (HF), le chlorure d'hydrogène (HCl) ou un fluorocarbure gazeux (CF₄, CHF₃, CClF₂, ou analogue), ou un liquide, tel que l'acide fluorhydrique (HF), l'acide chlorhydrique (HCl) ou un fluorocarbure liquide (C₂F₃Cl₄ ou analogue).

21. Procédé de fabrication d'un dispositif de conversion photo-électrique selon l'une des revendications 16, 17 et 18, dans lequel le balayage au faisceau laser de la seconde couche formant électrode est effectué dans une atmosphère d'oxygène.
